(19) Europäisches Patentamt
European Patent Office
Office européen des brevets

(11) **EP 0 985 328 B1**

(12) **EUROPEAN PATENT SPECIFICATION**

(45) Date of publication and mention
of the grant of the patent:
**08.03.2006 Bulletin 2006/10**

(51) Int Cl.:
*H04R 25/00* (2006.01)  *H03H 17/02* (2006.01)

(21) Application number: **98914754.1**

(22) Date of filing: **16.04.1998**

(86) International application number:
**PCT/CA1998/000329**

(87) International publication number:
**WO 1998/047313 (22.10.1998 Gazette 1998/42)**

(54) **FILTERBANK STRUCTURE AND METHOD FOR FILTERING AND SEPARATING AN INFORMATION SIGNAL INTO DIFFERENT BANDS, PARTICULARLY FOR AUDIO SIGNALS IN HEARING AIDS**

FILTERBANKANORDNUNG UND VERFAHREN ZUR FILTERUNG UND TRENNUNG EINES INFORMATIONSSIGNAL IN UNTERSCHIEDLICHEN FREQUENZBÄNDERN, INSBESONDERE FÜR AUDIOSIGNALE IN HÖRHILFEGERÄTEN

STRUCTURE DE BANC DE FILTRES ET PROCEDE SERVANT A FILTRER ET A SEPARER UN SIGNAL D'INFORMATION EN DIFFERENTES BANDES, EN PARTICULIER POUR DES SIGNAUX SONORES DANS DES PROTHESES AUDITIVES

(84) Designated Contracting States:
**AT BE CH CY DE DK ES FI FR GB GR IE IT LI LU MC NL PT SE**

(30) Priority: **16.04.1997 US 41977 P**
**16.04.1997 US 41990 P**

(43) Date of publication of application:
**15.03.2000 Bulletin 2000/11**

(73) Proprietor: **Emma Mixed Signal C.V.**
**1043 BW Amsterdam (NL)**

(72) Inventors:
• **BRENNAN, Robert**
**Kitchener, Ontario N2H 2A7 (CA)**
• **SCHNEIDER, Anthony, Todd**
**Waterloo, Ontario N2L 5M3 (CA)**

(74) Representative: **Hackney, Nigel John et al**
**Mewburn Ellis LLP**
**York House,**
**23 Kingsway**
**London WC2B 6HP (GB)**

(56) References cited:
WO-A-83/02212          WO-A-95/08248
SE-B- 462 885          US-A- 4 508 940
US-A- 4 852 175          US-A- 5 029 217

• LUNNER T ET AL: "A DIGITAL FILTERBANK HEARING AID DESIGN, IMPLEMENTATION AND EVALUATION" SPECTRAL ESTIMATION AUDIO AND ELECTROACOUSTICS, TORONTO, MAY 14 - 17, 1991, vol. 5, no. CONF. 16, 14 May 1991, pages 3661-3664, XP000242759 INSTITUTE OF ELECTRICAL AND ELECTRONICS ENGINEERS
• JU-HONG LEE ET AL: "FILTER DESIGN FOR POLYPHASE FILTER BANKS WITH ARBITRARY NUMBER OF SUBBAND CHANNELS" PROCEEDINGS OF THE INTERNATIONAL SYMPOSIUM ON CIRCUITS AND SYSTEMS, PORTLAND, MAY 8 - 11, 1989, vol. 3, no. SYMP. 22, 8 May 1989, pages 1720-1723, XP000131394 INSTITUTE OF ELECTRICAL AND ELECTRONICS ENGINEERS

EP 0 985 328 B1

## Description

FIELD OF THE INVENTION

This invention relates to a filterbank structure and a method for filtering and separating an information signal into different bands, particularly for such filtering and separation of audio signals in hearing aids. This invention more particularly relates to such a technique carried out using digital signal processing in hearing aids. This invention more particularly relates to a method and architecture for a digital filterbank for hearing aid applications.

BACKGROUND OF THE INVENTION

Hearing loss is generally associated with a loss of hearing sensitivity which is a function of frequency. The most common type of sensitivity loss is an increasing function of frequency. Sensitivity is typically a function of speech level as well. Hence, loud sounds should be amplified less than soft sounds. It has been long known that a hearing aid should treat the various frequency components of speech differently to render them intelligible to a hearing impaired person.

Known analog hearing aids use relatively simple methods to alter their frequency shaping and dynamic range compression to mitigate the loss in hearing sensitivity for frequency and level. Swedish Patent No. 462 885 B dislcoses a programmable hearing aid with a programmable filterbank. The filterbank is a digital control "bi-quad" filter. By varying the programmable filter parameters, the response of the digital filterbank can be low pass, high pass, band pass, band stop. The centre frequencies, filter type, and filter order may all be reprogrammable paremeters. The filterbank is a single channel filter and does not separate the input signal into a plurality of frequency bands. The system of Swedish Patent No. 462 885 B therefore has limited processing flexibility.

The design of digital hearing aids involves numerous trade-offs between processing capability, flexibility, power consumption and size. Minimizing both chip size and power consumption are important design considerations for integrated circuits used in hearing aids. Fully-programmable implementations of digital hearing aids (i.e., those that use a software-controlled digital signal processor) provide the most flexibility. However, with current technology, a fully-programmable digital signal processor (DSP) chip or core consumes a relatively large amount of power. An application specific processor (typically implemented using an application specific integrated circuit or ASIC) will consume less power and chip-area than a fully-programmable, general-purpose DSP core for equivalent processing capabilities, but is less flexible and adaptable. For example, United States Patent No. 4,852,175 to Kates discloses a hearing aid signal processing system in which the absolute quantity of noise in each of a plurality of non-overlapping frequency bands is estimated. A programmable polyphase signal processor performs all of the filtering and processing steps in the system including analysis, synthesis, noise estimation, and gain control.

Digital hearing aids typically operate at very low supply voltages (1 volt). If circuits for digital hearing aids are fabricated using conventional high-threshold (0.6 volt or greater) semiconductor technology they are not able to operate at high clock speeds (>1 MHz) because of the small difference between the supply voltage and threshold voltage. Even if a DSP core is capable of executing one instruction per clock cycle this limits the computation speed to less than 1 million instructions per second (1 MIPS). This is not a high enough computation rate to implement advanced processing schemes like adaptive noise reduction or multi-band wide dynamic range compression with 16 or more bands. Because ASIC implementations overcome the sequential nature of a typical DSP core and permit calculations to be made in parallel, they can provide more computational capability, i.e. a higher computation rate, and can be used to implement computationally intensive processing strategies.

A major disadvantage of digital hearing aids that are implemented using ASICs is that they are entirely dedicated or "hardwired" and lack the flexibility required for refinements in processing schemes that will take place over time as knowledge of hearing loss increases. In contrast, digital hearing aids that use programmable DSP cores can be re-programmed to implement a wide range of different processing strategies.

The basic processing strategy used by the vast majority of hearing aids applies frequency specific gain to compensate for hearing loss. Adaptive processing schemes like compression and noise reduction extend this basic processing scheme by adjusting the frequency specific gain in response to changes in input signal conditions.

SUMMARY OF THE INVENTION

Digital techniques promise far greater possibilities for signal processing to aid the hearing impaired. The present inventors have realized that digital filterbanks offer a flexible framework for separating the input signal into a number of independent frequency bands, for separate or combined processing. This allows great processing flexibility as the bands can be treated independently to compensate more precisely for hearing loss.

Furthermore, the present invention is based on the realization that significant advantages can be obtained if the benefits of a fully-programmable DSP core are combined with dedicated hardware resources such as an ASIC. More specifically, the present invention proposes implementing the fixed portion of the processing strategy in a dedicated ASIC and using a programmable DSP core or other form of microcontroller to control the parameters of the fixed processing scheme. This combined approach provides improved flexibility and processing capabilities while still achieving low power consumption and small chip size. In particular, it is realized that signal processing in a digital filterbank hearing aid, occurs at two different rates. High-speed processing that processes input samples at the sampling rate is used to split the incoming signal into a plurality of frequency bands. The parameters of the processing strategy (e.g., filterbank channel gains) are typically adjusted at a much slower rate (on the order of milliseconds) in response to changes in input signal conditions. The present invention uses a dedicated ASIC to implement the high-speed processing and a programmable digital signal processor for the lower-speed processing, to achieve a balance between the conflicting requirements of flexibility, processing capability, size and power consumption. The dedicated hardware resources of the ASIC can be optimized to carry out the anlysis and synthesis filtering steps according to the present invention.

In accordance with the present invention, there is provided a filterbank for filtering an information signal, the filterbank structure comprising a filter means defining a filter bandwidth, said filter means filtering said audio signal and separating said audio signal into a plurality of frequency band signals each representing one of a plurality of uniformly spaced frequency bands within said filter bandwidth, said frequency bands being stacked in an even or odd manner and said frequency bands abutting, overlapping, or being spaced apart from one another, said frequency band signals being downsampled by a decimation factor, wherein the filter means includes a selection input enabling at least one of the following to be selected: (i) the number of frequency band signals, (ii) the bandwidth of said frequency bands, (iii) whether said frequency bands are stacked in an even or odd manner, (iv) whether said frequency bands abut, overlap, or are spaced apart from one another, and (v) the decimation factor for downsampling said frequency band signals.

It is to be appreciated that while it is envisaged that the number of frequency bands and their bandwidth will usually be parameters that can be adjustable by the selection input, this is not always the case. More generally, the filterbank can be configured to enable one or more of usual parameters of a digital filterbank to be adjustable, and these can include: the number of bands; the width of each band; whether the bands have abutting band edges, overlap or are spaced apart; coefficients for both analysis and synthesis windows; whether there is any relationship between the analysis and synthesis windows; even or odd stacking of bands; and the degree of oversampling above the critical sampling rate. Details of these parameters are set out below.

Preferably, the selection input enables at least one of the number of frequency bands and whether said frequency bands are stacked in an even or odd manner to be selected, said number of frequency bands being equal to N, and the filter means comprises (a) a first analysis filterbank means for separating said signal into a plurality of N separate frequency band signals; (b) processing means for receiving and processing each of said separate frequency band signals to provide N separate processed frequency band signals; and (c) a second synthesis filterbank means for receiving and recombining the N separate processed frequency band signals into a single output signal, wherein both of the first analysis filterbank means and the second synthesis filterbank means are connected to the selection input, to enable the number of bands and the band width of each frequency band to be selected, the processing means being coupled between the first analysis filterbank means and the second synthesis filterbank means.

In another aspect of the present invention, the filterbank comprises a dedicated application specific integrated circuit (ASIC), said ASIC including the first analysis and the second synthesis filterbanks, and a programmable digital signal processor for controlling the number of frequency bands and the bandwidth of each frequency band, said digital signal processor being provided with the selection input.

The filterbank may be adapted to receive a single real monaural information signal, wherein said transform means generates non-negative frequency band signals and negative frequency band signals, said negative frequency band signals being derivable from the non-negative frequency band signals, and said processing means processes only said non-negative frequency band signals. Alternatively is adapted to filter an audio signal comprising first and second real monaural information signals which are combined into a complex stereo signal and wherein said transform means generates N combined frequency band signals, and wherein said processing means includes: (a) channel separation means for separating the N combined frequency band signals into the N frequency band signals corresponding to said first information signal and the N frequency band signals corresponding to said second information signal, each of said N frequency band signals comprising non-negative and negative frequency band signals; (b) first independent channel processing means connected to the channel separation means for receiving and processing each of said separate frequency band signals of said first information signal to provide a first set of N separate processed frequency band signals; (c) second independent channel processing means connected to channel separation means for receiving and processing each of said separate frequency band signals of said second information signal to provide a second set of N separate processed frequency band signals; and (d) channel combination means connected to the first and second independent channel processing means for combining said first set of N processed separate frequency band signals and said second set of N processed separate frequency band signals.

In accordance with another aspect, the present invention provides an apparatus, for use in a digital hearing aid, the apparatus comprising: a dedicated application specific integrated circuit, which includes analysis filter means for separating a signal into a plurality of different frequency band signals in different frequency bands and synthesis filter means for recombining the frequency band signals into an output signal; a programmable digital signal processor; and a multiplication means connected to the programmable digital signal processor and to the application specific integrated circuit, wherein the multiplication means multiplies each band by a desired gain, and wherein the gain for each band is controlled by the programmable digital signal processor.

In accordance with a further aspect of the present invention, there is provided a method of processing an information signal to selectively modify different frequency bands, the method comprising the steps of: (1) defining a filter frequency bandwidth to be analyzed; (2) dividing the filter bandwidth into a plurality of uniformly spaced bands, said frequency bands being stacked in an even or odd manner and said frequency bands abutting, overlapping, or being spaced apart from one another; (3) filtering the information signal to separate the signal into a plurality of frequency band signals, each representing one of said uniform filter bands, said frequency band signals being downsampled by a decimation factor; (4) processing the frequency band signals; (5) recombining the signals of the individual bands to form an output signal; and (6) providing an input for enabling at least one of the following to be selected: (i) the number of frequency band signals, (ii) the bandwidth of said frequency bands, (iii) whether said frequency bands are stacked in an even or odd manner, (iv) whether said frequency bands abut, overlap, or are spaced apart from one another, and (v) the decimation factor for downsampling said frequency band signals. Preferably, step (4) comprises setting a gain for each frequency band and multiplying each frequency band signal by the respective set gain. Also preferably, the method further comprises (a) in step (3) separating said signal into N separate frequency band signals; (b) in step (4) processing each of said separate frequency band signals to provide N separate processed frequency band signals; (c) in step (5), recombining the N separate processed frequency band signals to form the output signal; and (d) selecting either the number of frequency bands or whether said frequency bands are stacked in an even or odd manner.

In one embodiment, the method includes transforming the information signal into the frequency domain, providing N separate frequency band signals in the frequency domain, and effecting an inverse transform of the N separate processed frequency band signals into the output signal in the time domain.

The signal, in one variant of the invention, is filtered to give a plurality of evenly stacked bands, as described in Crochiere, R E. and Rabiner, L.R., *Multirate Digital Signal Processing,* (Prentice-Hall, 1988) which is incorporated herein by reference. Alternatively, it can be filtered to give a plurality of oddly stacked bands. This has the advantage that the placement of the band edges is selectable and this technique gives twice the number of potential band edges. The band edges can be selected depending on the characteristics of a person's hearing loss. In further variants of the invention, other parameters of a digital filterbank are made adjustable either alone or in combination.

## DESCRIPTION OF THE DRAWING FIGURES

For a better understanding of the present invention and to show more clearly how it may be carried into effect, reference will now be made, by way of example, to the accompanying drawings, which show a preferred embodiment of the present invention, and in which:

Figure 1 shows schematically a block diagram of an ASIC data path processor and a programmable DSP unit in accordance with the present invention;
Figures 2a and 2b show schematically stacking arrangements for even and odd uniform filterbanks;
Figures 2c and 2d show simulated stacking arrangements for even and odd uniform filterbanks showing typical filter characteristics;
Figures 3 and 3a show details of the filterbank analysis structure for monaural and stereo processing.
Figure 4 shows details of the filterbank synthesis structure.

## DESCRIPTION OF THE PREFERRED EMBODIMENT

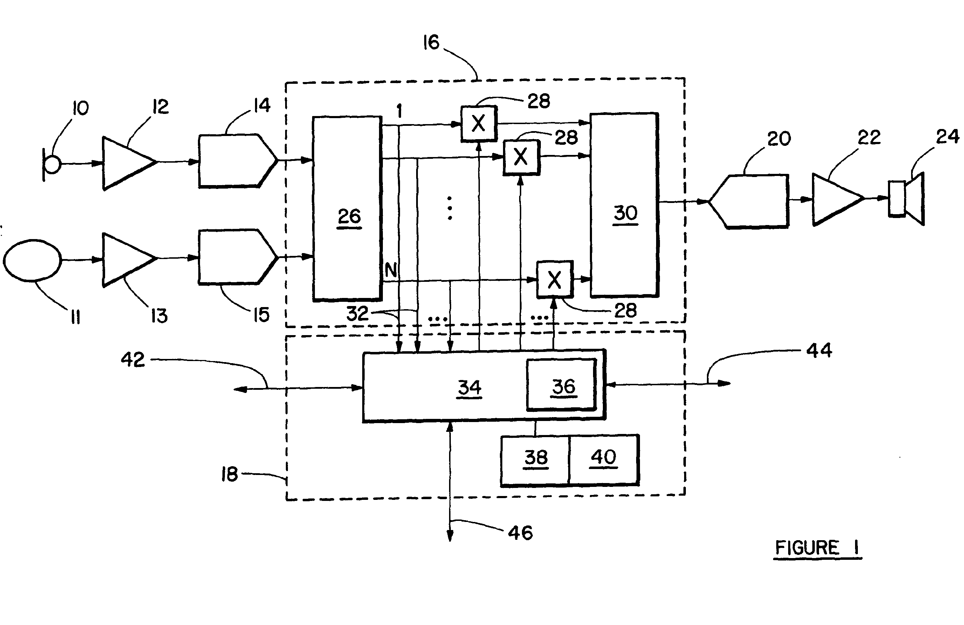

With reference to the drawings, the apparatus of the present invention has a microphone 10, as a first input, connected to a preamplifier 12, which in turn is connected to an analog-to-digital (A/D) converter 14. In known manner this enables an acoustic, audio-band signal, for example, to be received in the microphone, preamplified and converted to a digital representation in the A/D converter 14. A secondary input 11 (which may also comprise a microphone) may also be connected to a preamplifier 13 which is in turn connected to an analog-to-digital (A/D) converter 15. While Figure 1 shows an audio input signal or signals, the present invention is not limited to use with such signals and can have other information signals, such as a seismological signal, as an input. In the present invention, the term monaural describes embodiments which process one digital stream and the term stereo describes embodiments which process two digital streams. Theoretically, according to the Nyquist Sampling Theorem, provided a signal is sampled at a rate of at least twice the input signal bandwidth, there will be adequate information content to reconstruct the signal. This minimum sampling rate required for reconstruction is commonly referred to as the Nyquist rate.

The output of the A/D converter 14 (and where a secondary input exists, the output of A/D converter 15) is connected to a filterbank application specific integrated circuit (ASIC) 16 as shown in Figure 1 or, alternatively, directly to a programable DSP unit 18 via a synchronous serial port. Additional A/D converters (not shown) may be provided to permit digital processing of multiple separate input signals. Further input signals may be mixed together in the analog domain prior to digitization by these A/D converters. Mixing may also be done in the digital domain using the programmable DSP prior to processing by a monaural filterbank. The output of the filterbank ASIC 16 is connected to a digital-to-analog (D/A) converter 20. The converter 20 is in turn connected through a power amplifier 22 to a hearing aid receiver 24. Thus, the filtered signal, in known manner, is converted back to an analog signal, amplified and applied to the receiver 24.

The output of the A/D converter 14, and any additional A/D converter that is provided, may, instead of being connected to the ASIC 16 as shown, be connected to the programmable DSP 18 via a synchronous serial port. Similarly, the output D/A converter 20 can alternatively be connected to the programmable DSP 18.

Within the filterbank ASIC 16, there is an analysis filterbank 26, that splits or divides the digital representation of the input signal or signals into a plurality of separate complex bands 1-N. As shown in Figure 1, each of these bands is multiplied by a desired gain in a respective multiplier 28. In the case of monaural processing, the negative frequency bands are complex conjugate versions of the positive frequency bands. As a result, the negative frequency bands are implicitly known and need not be processed. The outputs of the multipliers 28 are then connected to inputs of a synthesis filterbank 30 in which these outputs are recombined to form a complete digital representation of the signal.

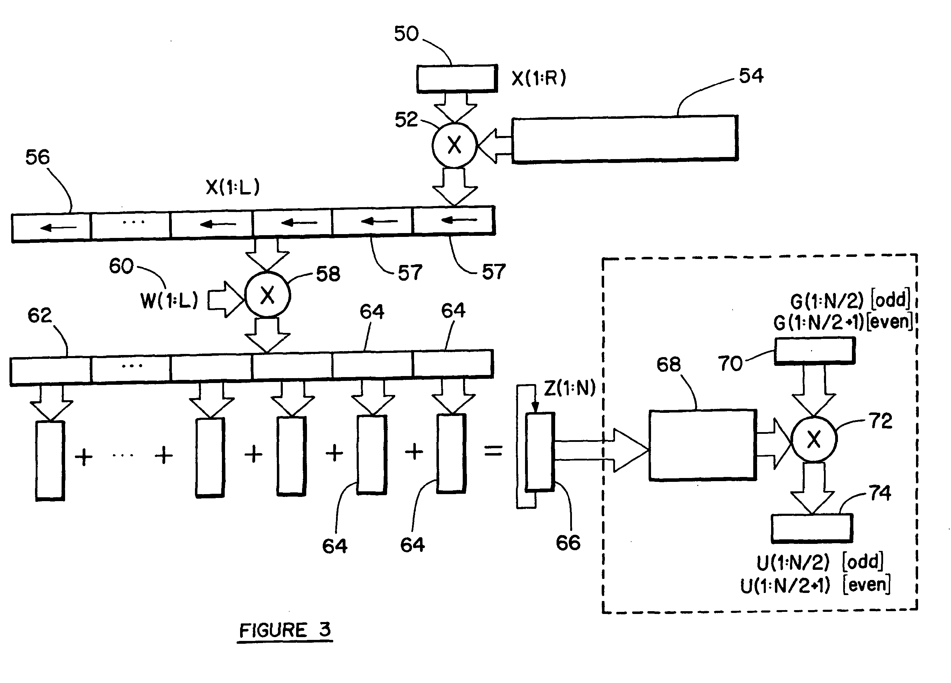

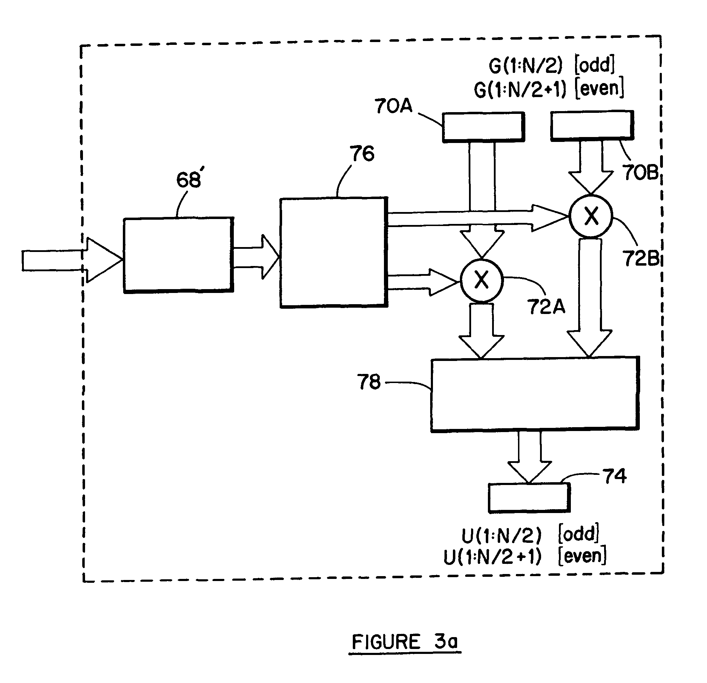

For stereo processing, the complex conjugate symmetry property does not hold. In this case, the N band outputs are unique and represent the frequency content of two real signals. As indicated below and shown in Figure 3a, the band outputs must first be processed to separate the content of the two signals from each other into two frequency domain signals before the gain multiplication step is performed. The two frequency separated signals are complex conjugate symmetric and obey the same redundancy properties as described previously for monaural processing. Multiplier resource 28 must, therefore, perform two sets of gain multiplications for the non-redundant (i.e. positive frequency) portion of each signal. After multiplication, the signals are combined into a monaural signal, and further processing is identical to the monaural case.

In known manner, to reduce the data and processing requirements, the band outputs from the analysis filterbank 26 are downsampled or decimated. Theoretically, it is possible to preserve the signal information content with a decimation factor as high as N, corresponding to critical sampling at the Nyquist rate. This stems from the fact that the bandwidth of the N individual band outputs from the analysis filterbank 26 is reduced by N times relative to the input signal. However, it was found that maximum decimation, although easing computational requirements, created severe aliasing distortion if adjacent band gains differ greatly. Since this distortion unacceptably corrupts the input signal, a lesser amount of decimation was used. In a preferred embodiment, the band outputs are oversampled by a factor OS times the theoretical minimum sampling rate. The factor OS represents a compromise or trade-off, with larger values providing less distortion at the expense of greater computation (and hence power consumption). Preferably, the factor OS is made a programmable parameter by the DSP.

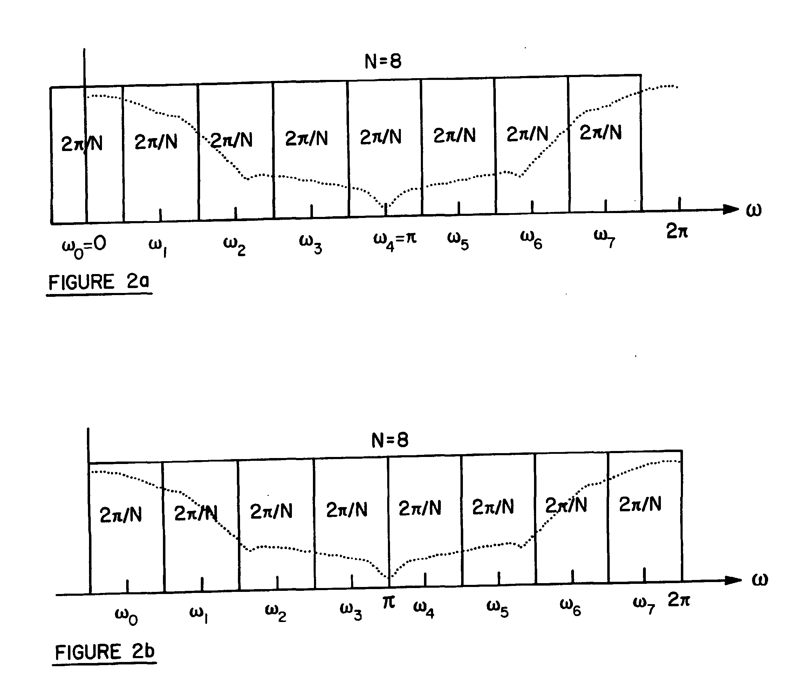

To reduce computation, a time folding structure is used as is shown in the transform-based filter bank of Figure 3, and described in greater detail below. After applying a window function, which is also referred to as a prototype low pass filter, to the incoming signal, the resulting signal is broken into segments, stacked and added together into a new signal. This signal is real for monaural applications and complex for stereo applications. The output of the analysis filterbank is the (even or odd) discrete Fourier transform (DFT) of this segment signal (the DFT is normally implemented with a fast Fourier transform algorithm). For stereo applications a complex DFT must be used, whereas for monaural applications a real input DFT may be used for increased efficiency. As will be known to those skilled in art, the odd DFT is an extension of the even or regular DFT as described in Bellanger, M., *Digital Processing of Signals,* (John Wiley and Sons, 1984), which is incorporated herein by reference. Thus in the preferred embodiment, the present invention comprises a transform-based filterbank in which the action of the DFT is as a modulator or replicator of the frequency response of the prototype low pass filter (i.e. the window function), so that the discrete Fourier transform of the windowed time domain signal or signals results in a series of uniformly spaced frequency bands which are output from the analysis filterbank. The time-folding structure of the present invention further allows the number of frequency bands and their width to be programmable. In doing so, this time-folding structure reduces the size of the DFT from the window size to the segment size and reduces complexity when the desired number of filter bands is less than the window size. This technique is shown generally for a filterbank of window size L and DFT size N in Figure 3. In total there are N full frequency bands including both non-negative and negative frequency bands, represented by N frequency band signals. For monaural applications these bands (i.e. the band signals) may be processed directly. In stereo applications, the frequency content of the two input signal streams are first separated as shown in Fig. 3a. As previously indicated, in the monaural case, the negative frequency bands are redundant because they can be exactly derived from the positive frequency bands (since they are complex conjugate versions of each other). As will be obvious to one skilled in the art, the positive frequency bands, i.e. the positive frequency band signals, could alternatively be derivable from the non-positive frequency bands, i.e. the non-positive frequency band signals. Effectively, therefore, there are N/2 non-negative complex frequency bands of normalized width $\frac{2\pi}{N}$ for odd stacking; and there are N/2 - 1 non-negative complex frequency bands of width $\frac{2\pi}{N}$ and 2 non-negative real frequency bands of width $\frac{\pi}{N}$ for even stacking. This is illustrated in Figure 2a for N=8.

As shown in Figure 2a, the output of each filterbank channel is band limited to $\frac{2\pi}{N}$ and each band output can be decimated by the factor R (i.e. its sampling rate is reduced by keeping only every Rth sample) without, theoretically, any loss of fidelity if R ≤ N. As mentioned earlier, it is not possible to maximally decimate this filterbank (i.e. to have the input sample shift R equal the DFT size N) and obtain useful results when extensive manipulation of the frequency content is required as in hearing aids. Accordingly, the decimation factor, which is N for critical sampling, is less by a factor of OS. This is accomplished by shifting the input samples by R= N/OS rather than by N. This is advantageous in reducing the group delay since the processing latency (i.e. the delay created by the FIFO shifting) is smaller by the factor OS. The increase in the band sampling rate eases the aliasing requirements on the analysis filter. Additionally, spectral images are pushed further apart reducing the image rejection requirements on the synthesis filter. Lowering the requirements of these filters further reduces delay (since these filters can be simpler, i.e. of lower order). While maximum oversampling, i.e. OS = N, provides for optimal reconstruction of the input signal or signals, this results generally in unacceptable computational expense.

With reference to Figure 3, the overlap-add analysis filterbank 26 includes an input 50 for R samples. In known manner, the exact size or word length of each sample will depend upon the accuracy required, whether it is fixed-point or floating-point implementation etc. The input 50 is connected to a multiplication unit 52 which also has an input connected to a circular ± sign sequencer input 54 having a length of 2*OS samples. This circular sequencer input 54, which may be generated by a shift register, has a series of inputs for odd stacking of the filter bands and inputs for even stacking of the filter bands.

In the multiplication unit 52, for the even filterbank structure, each block of R input samples is multiplied by +1, so as to remain unchanged. For the even DFT, which has basis functions ending in the same sign (i.e. which are continuous), no modulation is required to obtain continuous basis functions.

For the odd filterbank structure, the first OS blocks of R input samples are multiplied by +1 and the next OS blocks by -1, the next OS blocks by +1, etc. Since the odd DFT has basis functions ending in opposite signs (i.e. which are not continuous), this modulation serves to produce continuous basis functions.

The output of the multiplication unit 52 is connected to a first buffer 56 holding L samples, indicated as X(1:L). These samples are split up into individual segments 57, each of which contains R samples. The buffer 56 is sized so that the L samples form a desired window length. The larger the window length L, the more selective each channel becomes at the expense of additional delay. The buffer 56 is connected to a second multiplication unit 58, together with a window function 60, indicated as W(1:L). The modulation property of the fast Fourier transform procedure creates a complete uniformly spaced filterbank by replicating the frequency response of the window function (also referred to as the prototype low-pass filter) at equally spaced frequency intervals. It is necessary to properly design this window function to give a desired passband and stopband response to the filter bands and thereby reduce audible aliasing distortion.

The window function (which is a prototype low pass filter) ideally satisfies the requirements for a good M-band filter, i.e. a good low pass filter which has zeros at every interval of N samples. Other window functions can also be used. See Vaidyanathan, P.P., "Multirate Digital Filters, Filter Banks, Polyphase Networks, and Applications: A Tutorial", *Proc. IEEE,* Vol. 78, No. 1, pp. 56-93 (January 1990), which is incorporated herein by this reference. As will be appreciated by those skilled in the art, this filter may be designed as a windowed sinc function or by using Eigenfilters (see Vaidyanathan, P.P., and Nguyen, T.Q., "Eigenfilters: A New approach to least-squares FIR filter design and applications including Nyquist filters", *IEEE Trans. on Circuits and Systems,* Vol. 40, No. 4 (December 1994), pp. 11-23). The coefficients of the window function are generated by the programmable DSP or generated and stored in non-volatile memory. A general window is typically stored in non-volatile memory, however for the parametric classes of windows based on the sinc function, the window function need not be stored as it may be calculated on system initialization using only a few parameters.

The output of the second multiplication unit 58 is connected to a second output buffer 62. This output buffer 62 again has the same L samples, arranged into segments 64. Here, the segments contain N samples. In a typical embodiment, N might equal 32 and the number of channels is 16 (for an odd DFT/odd stacking) or 17 (for an even DFT/even stacking -- because of the two half bands). For adequate selectivity with band aliasing reduction greater than 55 dB, a window length L of 256 samples can be used (the window length L is constrained to be a multiple of N, and in preferred embodiments is also a multiple of $2^N$ for computational simplicity) and the over-sampling factor, OS, should be 2 or greater. For example, letting OS equal 2 results in R equal to 16 (i.e N/OS). As mentioned earlier, for monaural applications, the samples are real, and for stereo applications the samples are complex.

The segments are separated, and as indicated below the buffer 62, individual segments 64 are added to one another to effect the time folding or time aliasing operation, and thereby reduce the number of necessary computations in processing the input signal or signals. The details of the time folding step are described in Crochiere, R.E. and Rabiner, L.R., *Multirate Digital Signal Processing, supra.* Ideally, the time folding step does not result in any loss of information, and in practical implementations any resulting loss can be made insignificant. The addition is performed, and the result is supplied to circular shift sequencer 66, which is preferably a circular shift register, as shown in Figure 3. This shift register 66 holds N samples and shifts the samples by R samples (where R=N/OS) at a time.

The time aliased stacked and summed total is then subject to an odd FFT, or even FFT as required, by the FFT unit 68 (as shown in Figure 3 for monaural applications) or the FFT unit 68' (as shown in Figure 3a for stereo applications) to produce the DFT. The DFT provided by 68 is an N-point transform with real inputs (monaural), and the DFT provided by 68' is an N-point transform with complex inputs (stereo). For monaural applications, the non-negative frequency components of the DFT output by the FFT unit 68, and a set of gain values G(1:N/2) for odd stacking (or G(1:N/2 + 1) for even stacking) from a multiplier resource unit 70, are connected to a multiplication unit 72. This gives an output 74 of U(1:N/2) for odd stacking (or U(1:N/2 + 1) for even stacking) which is complex, i.e. with a magnitude and phase, in known manner.

As illustrated in Fig. 3a, for stereo applications the two channels must first, i.e. before the multiplication step, be separated in a stereo channel separation step indicated at 76. To illustrate, consider the case of two real time domain signals x1 and x2 which have been combined into a single complex signal x1 + jx2, where x1 and x2 are sample vectors which are N frequency domain samples long. Since the filterbank operation is linear, the resulting output from the analysis filterbank is X1 + jX2, where X1 and X2 are also N samples long. The frequency information of the two channels X1 and X2 are separable by using the symmetry relationships present in the N band outputs (i.e. the first channel spectrum has a symmetric real portion and an anti-symmetric imaginary portion, whereas the second channel has an anti-symmetric real portion and a symmetric imaginary portion). As a result, well known operations are all that are necessary to separate the two channels: see B.P. Flannery, S.A. Teukolsky, W.T. Vetterling, *Numerical Recipes in* C, (Cambridge University Press: 1991), Chapter 12.

After separation, the non-negative frequency components of these data streams are each multiplied by a separate set of gain values from multiplier resources 70A and 70B respectively (multiplier resources 70A and 70B typically represent the separate processing of the left and right channels, and each contains N/2 values for odd stacking or N/2 + 1 values for even stacking). After the multiplication steps at 72A and 72B, the two channels are combined in a combine channels step indicated at 78, which provides an output 74 as in the monaural case. The combination step 78 is simply the point by point summation of the two frequency domain streams.

As compared to Figure 1, the multiplication units 72 of Fig 3 and 72A and 72B of Fig. 3a are equivalent to the multiplication units 28 shown in Figure 1.

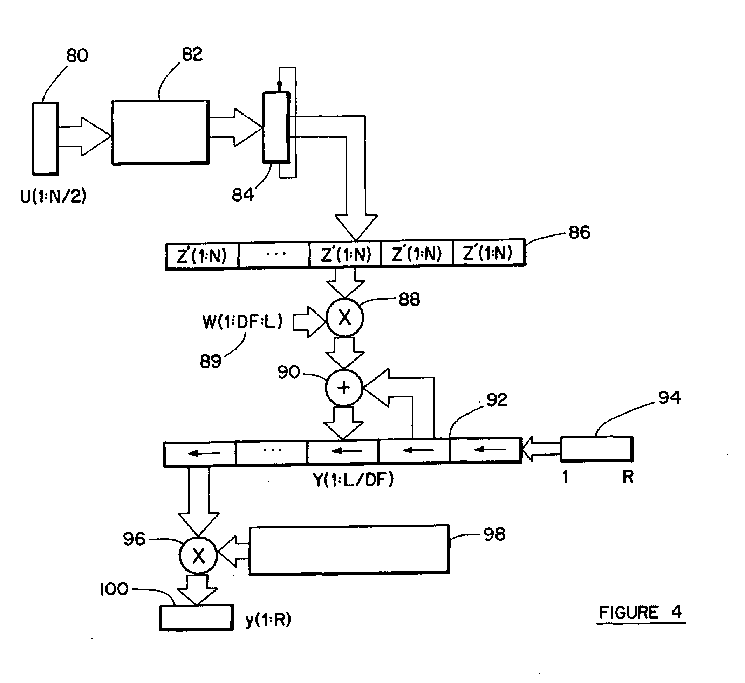

Reference will now be made to Figure 4, which shows the corresponding synthesis filterbank. Here, the input is shown at 80 of the complex representation of the signal in the frequency domain, U(1:N/2) for odd stacking (or U(1:N/2 +1) for even stacking). This is converted to the time domain by an inverse DFT, which again is odd or even as required and which is implemented by the inverse FFT (IFFT) algorithm unit 82. In known manner, the IFFT unit 82 produces a real output.

Corresponding to the circular shift sequence 66, an input circular shift sequencer 84, which can comprise a shift register, holds N samples and circularly shifts the samples in steps that are decreasing multiples of R samples (where R=N/OS) at a time. This shift undoes the shift performed by 66.

The N-sample output of the circular shift sequence 84, Z'(1:N), is replicated and concatenated as necessary to form an $^L/_{DF}$ sample sequence in input buffer 86, where DF represents the synthesis window decimation factor (and is not to be confused with the analysis filterbank time domain decimation factor R). As discussed below, the parameter DF is less than or equal to OS when the synthesis window function is based on a decimated version of the analysis function; otherwise DF equals 1. This replication and concatenation step is the inverse operation of the time aliasing step previously described. As illustrated in Figure 4, this input buffer is shown as $^L/_{DF*N}$ N-sample segments which have been periodically extended from the circular shift sequence 84. It is possible for $^L/_{DF*N}$ to be a non-integer fraction. For large synthesis window decimation factors, DF, $^L/_{DF*N}$ may also be less than 1, and in such cases the input buffer 86 becomes shorter than N samples and comprises only the central portion of Z'(1:N).

The output of the buffer 86 is connected to a multiplication unit 88. The multiplication unit 88 has another input for a synthesis window 89 indicated as W(1: DF:L). The window 89 which is L/DF samples long removes unwanted spectral images. The analysis window has a cutoff frequency of $\frac{\pi}{N}$ and the synthesis window has a cutoff frequency of $\frac{\pi}{R} = \frac{OS * \pi}{N}$. The latter may be based on the decimated analysis window by setting DF ≤ OS if the "droop" (or attenuation) of the analysis filter at its cutoff frequency divided by DF, i.e. at $\frac{\pi}{N * DF}$, is not significant since this represents the attenuation of the synthesis window at $\frac{\pi}{N}$. In such a case, the synthesis window function is generated by decimating the analysis window coefficients by a factor of DF ≤ OS. This constraint (i.e. having the synthesis window based on the analysis window) is preferable for memory limited applications and may be removed, advantageously, if sufficient memory is available. As indicated previously, L corresponds to the number of samples held in the buffer 56 in the analysis filterbank (Figure 3), and DF represents the synthesis window decimation factor, where for DF equal to 2 every other sample is deleted. Similarly to the analysis window function, the synthesis window function W(1:DF:L) (this notation indicates a vector derived from a vector W by starting at index 1 and selecting every DF'th sample not exceeding index L) is ideally a good M-band filter, i.e. a good low pass filter which has zeros at every interval of N/DF samples. However, as with the analysis window, other window functions can also be used. The output of the multiplication unit 88 is connected to a summation unit 90. The summation unit 90 has an output unit connected to an output buffer 92. The buffer 92 has an input at one end for additional samples and an additional sample input 94, so that the output buffer 92 acts like a shift register that shifts R samples each time a new input block is received.

The output of the summation unit 90 is supplied to the buffer 92. As indicated by the arrows, the contents of the buffer 92 are periodically shifted to the left by R samples. This is achieved by adding R zeros to the right hand end of the buffer 92, as viewed. Following this shift, the contents of the buffer 92 are added to the product of W(1:DF:L) and the periodically extended buffer 86. The result is stored in the buffer 92 which holds $^L/_{DF}$ samples (or equivalently $^L/_{DF*N}$ N-sample segments). As previously explained, the buffer 92 may be less than one N-sample in length for large synthesis window decimation factors, DF.

It must be appreciated that, the output from the buffer 92, at the left hand end, is a signal which in effect has been added $^L/_{(DF•R)}$ times, so as to comprise portions of signals added together.

Because the coefficients of the window function W(1:L), the length of the window L, and the synthesis window decimation factor DF are all programmable parameters (by way of DSP unit 18), the present invention allows for a selectable number of channels, and a selectable range of bandwidths. As an additional advantage, the selectable even/odd stacking feature permits the bands to be shifted in unison by half of the channel bandwidth, without increasing delay. Thus the present invention allows the number of channels or bands and the width of those bands to be selected.

R samples at a time are taken from the buffer 92 and sent to a multiplication unit 96. Mirroring the circular ± sign sequencer input 54, there is another circular ± sign sequencer input 98, which again has a series of multiplication factors of +1 or -1, depending upon whether an odd or even DFT is executed. This step exactly undoes the modulation step performed in the analysis stage.

After multiplication in the unit 96 by the appropriate factors, R samples are present at the output 100, as indicated as Y(1:R). These samples are fed to the D/A converter 20.

The resynthesis procedure in addition to generating the correct signal in each band, produces unwanted spectral images which, when over-sampled by OS, are spaced OS times farther apart than for critical sampling. The synthesis window performs the function of removing these images similar to the function of the analysis window in preventing aliasing. Since these window functions are related, when memory is scarce, it is preferable to use a synthesis window related to the analysis window in order to conserve memory. In general, the reconstruction window can conveniently be the synthesis window decimated by DF, the synthesis window decimation factor.

As indicated at 32, connections to a programmable DSP 18 are provided, to enable the DSP to implement a particular processing strategy. The programmable DSP 18 comprises a processor module 34 including a volatile memory 36. The processor 34 is additionally connected to a nonvolatile memory 38 which is provided with a charge pump 40.

As detailed below, various communication ports are provided, namely: a 16 bit input/output port 42, a synchronous serial port 44 and a programming interface link 46.

The frequency band signals received by the DSP 18 represent the frequency content of the different bands and are used by the digital signal processor 34 to determine gain adjustments, so that a desired processing strategy can be implemented. The gains are computed based on the characteristics of the frequency band signals and are then supplied to the multipliers 28. While individual multipliers 28 are shown, in practice, as already indicated these could be replaced by one or more multiplier resources shared amongst the filterbank bands. This can be advantageous, as it reduces the amount of processing required by the DSP, by reducing the gain update rate and by allowing further computations to be done by the more efficient ASIC. In this manner, the memory requirements are also reduced and the DSP unit can remain in sleep mode longer.

The processor 34 can be such as to determine when gain adjustments are required. When gain adjustments are not required, the whole programmable DSP unit 18 can be switched into a low-power or standby mode, so as to reduce power consumption and hence to extend battery life.

In another variant of the invention, not shown, the multipliers 28 are omitted from the ASIC. The outputs from the analysis filterbank 26 would then be supplied to the digital signal processor 34, which would both calculate the gains required and apply them to the signals for the different bands. The thus modified band signals would then be fed back to the ASIC and then to the synthesis filterbank 30. This would be achieved by a shared memory interface, which is described below.

Communication between the ASIC 16 and the programmable DSP 18 is preferably provided by a shared memory interface. The ASIC 16 and the DSP 18 may simultaneously access the shared memory, with the only constraint being that both devices cannot simultaneously write to the same location of memory.

Both the ASIC 16 and programmable DSP 18 require non-volatile memory for storage of filter coefficients, algorithm parameters and programs as indicated at 38. The memory 38 can be either electrically erasable programmable read only memory (EEPROM) or Flash memory that can be read from or written to by the processor 34 as required. Because it is very difficult to achieve reliable operation for large banks (e.g., 8 kbyte) of EEPROM or Flash memory at low supply voltages (1 volt), the charge-pump 40 is provided to increase the non-volatile memory supply voltage whenever it is necessary to read from or write to non-volatile memory. Typically, the non-volatile memory 38 and its associated charge pump 40 will be enabled only when the whole apparatus or hearing aid "boots"; after this it will be disabled (powered down) to reduce power consumption.

Program and parameter information are transmitted to the digital signal processor 34 over the bi-directional programming interface link 46 that connects it to a programming interface. It will thus be appreciated that either the programming interface link 46 or the audio link through the microphone 10 (and optional second microphone for a stereo implementation), for the synthesized audio band signal, provide a selection input enabling the number of frequency bands, the width of each band, even or odd stacking, and other parameters to be selected. This interface receives programs and parameter information from a personal computer or dedicated programmer over a bi-directional wired or wireless link. When connected to a wired programming interface, power for non-volatile memory is supplied by the interface; this will further increase the lifetime of the hearing aid battery. As detailed in assignee's copending application no. 09/060,820, filed simultaneously herewith, a specially synthesized audio band signal can also be used to program the digital filterbank hearing aid.

The synchronous serial port 44 is provided on the DSP unit 18 so that an additional analog-to-digital converter can be incorporated for processing schemes that require two input channels (e.g., beamforming - beamforming is a technique in the hearing aid art enabling a hearing aid with at least two microphones to focus in on a particular sound source).

The programmable DSP 34 also provides a flexible method for connecting and querying user controls. A 16-bit wide parallel port is provided for the interconnection of user controls such as switches, volume controls (shaft encoder type) and for future expansion. Having these resources under software control of the DSP unit 18 provides flexibility that would not be possible with a hardwired ASIC implementation.

It is essential to ensure the reliability of the digital filterbank hearing aid in difficult operating environments. Thus, error checking or error checking and correction can be used on data stored in non-volatile memory. Whenever it is powered on, the hearing aid will also perform a self-test of volatile memory and check the signal path by applying a digital input signal and verifying that the expected output signal is generated. Finally, a watchdog timer is used to ensure system stability. At a predetermined rate, this timer generates an interrupt that must be serviced or the entire system will be reset. In the event that the system must be reset, the digital filterbank hearing aid produces an audible indication to warn the user.

A number of sub-band coded (i.e., digitally compressed) audio signals can be stored in the non-volatile memory 38 and transferred to volatile memory (RAM) 36 for real-time playback to the hearing aid user. The sub-band coding can be as described in chapters 11 and 12 of Jayant, N.S. and Noll, P., Digital Coding of Waveforms (Prentice-Hall; 1984) which is incorporated herein by this reference. These signals are used to provide an audible indication of hearing aid operation. Sub-band coding of the audio signals reduces the storage (non-volatile memory) that is required and it makes efficient use of the existing synthesis filterbank and programmable DSP because they are used as the sub-band signal decoder.

Thus, in accordance with the present invention, the digital processing circuit consists of an analysis filterbank that splits the digital representation of the input time domain signal into a plurality of frequency bands, a means to communicate this information to/from a programmable DSP and a synthesis filterbank that recombines the bands to generate a time domain digital output signal.

Ideally, a digital hearing aid, or indeed any hearing aid, would have non-uniform frequency bands that provide high resolution in frequency only where it is required. This would minimize the number of bands, while enabling modification of the gain or other parameters only where required in the frequency spectrum. However, the most efficient implementation of multi-channel filters, where the implementation is based on known transforms such as the Fourier transform, have uniform spacing. This naturally results from the fact that uniform sampling in time maps to uniform spacing in frequency. Thus, the present invention provides a multi-channel filter design with uniform spacing.

The number of bands, i.e. frequency resolution, required by a digital hearing aid depends upon the application. For frequency response adjustment at low frequencies, a digital hearing aid should be capable of adjustment in 250 Hz frequency steps. This fine adjustment allows the low-frequency gain targets at audiometric frequencies (the standard frequencies at which hearing characteristics are measured) to be accurately set.

The sampling rate used by a digital hearing aid is related to the desired output bandwidth. Since speech typically has little energy above 5 kHz and covering this frequency range results in highly intelligible speech, a sampling rate of 16 kHz, corresponding to a bandwidth of 8 kHz was chosen to allow a margin for safety. At a proportional increase in power consumption, however, a sampling rate of 24 kHz or beyond may prove desirable for higher fidelity. The minimum sampling rate required to achieve a desired output bandwidth should be selected to minimize power consumption. Adequate frequency coverage and resolution is achieved by using sixteen 500 Hz wide bands. This in turn requires a 32-point discrete Fourier transform. Although the bands are 500 Hz wide in this typical embodiment, the band edges may be adjusted in unison by 250 Hz steps. This is accomplished through the use of the DFT with even or odd stacking.

Compressor systems, which attempt to map variations in input signal level to smaller variations in output level, typically employ two or more bands so that high-level sounds in one band do not reduce the gain in other bands and impair speech perception. There is considerable debate on the number of bands that should be provided for an ideal compression system, assuming there is some perfect ideal system. The current consensus seems to be that two bands are better than one, but that more than two bands does not lead to improved speech reception thresholds. However, some results and opinions cast doubts on past results and methodologies that were used to evaluate multichannel compression systems.

For noise reductions systems, however, it is desirable to have a large number of bands so that only those portions of the spectrum that are noise can be attenuated, while not affecting parts of the spectrum without noise. To extract speech from noise, the filters should have small bandwidths to avoid removing speech harmonics. For the 8 kHz bandwidth mentioned, 128 bands provide bandwidths of 62.5 Hz which is adequate to avoid this problem.

There exist many possible tradeoffs between the number of bands, the quality of the bands, filterbank delay and power consumption. In general, increasing the number or quality of the filterbank bands leads to increased delay and power usage. For a fixed delay, the number of bands and quality of bands are inversely related to each other. On one hand, 128 channels would be desirable for flexible frequency adaptation for products that can tolerate a higher delay. The larger number of bands is necessary for the best results with noise reduction and feedback reduction algorithms.

On the other hand, 16 high-quality channels would be more suitable for extreme frequency response manipulation. Although the number of bands is reduced, the interaction between bands can be much lower than in the 128 channel design. This feature is necessary in products designed to fit precipitous hearing losses or other types of hearing losses where the filterbank gains vary over a wide dynamic range with respect to each other. Now, in accordance with the present invention, the filterbanks 26, 30 provide a number of bands, which is a programmable parameter. In accordance with the discussion above, the number of bands is typically in the range of 16-128.

A further increase in low-frequency resolution (i.e. more channels) may be obtained by further processing of one or more analysis filterbank output samples. This processing causes additional system delays since the additional samples must be acquired first before processing. This technique may be acceptable at low frequencies and for certain applications.

For applications requiring low processing delay and high frequencies, the converse of this technique is useful. Initial processing is done on fewer bands lowering the processing delay and increasing the bandwidth of the individual filter bands. Subsequent processing is performed on, typically, lower frequency bands to increase the frequency resolution at the expense of low-frequency delay; i.e. the lower frequency bands are further divided, to give narrower bands and greater resolution.

Commonly, there are two basic types of filterbanks, namely finite impulse response (FIR) and infinite impulse response (IIR). FIR filterbanks are usually preferred, because they exhibit better performance in fixed-point implementations, are easier to design and of constant delay. Frequency bands in a filterbank can be non-overlapping, slightly overlapping or substantially overlapped. For hearing aid applications, slightly overlapped designs are preferred, because they retain all frequency domain information while providing lower interaction between adjacent bands. Ideally, the bands would be designed to abut precisely against each other with no overlap. This however would require very large order filters with unacceptably large delay, so in practice low-order filters (128 to 512 points) are used, which creates slightly overlapped designs.

As discussed previously, uniform spacing of the bands is provided, because they can be implemented using fast frequency-domain transforms, e.g. either a FFT or a discrete cosine transform, which require less computation than time-domain implementations.

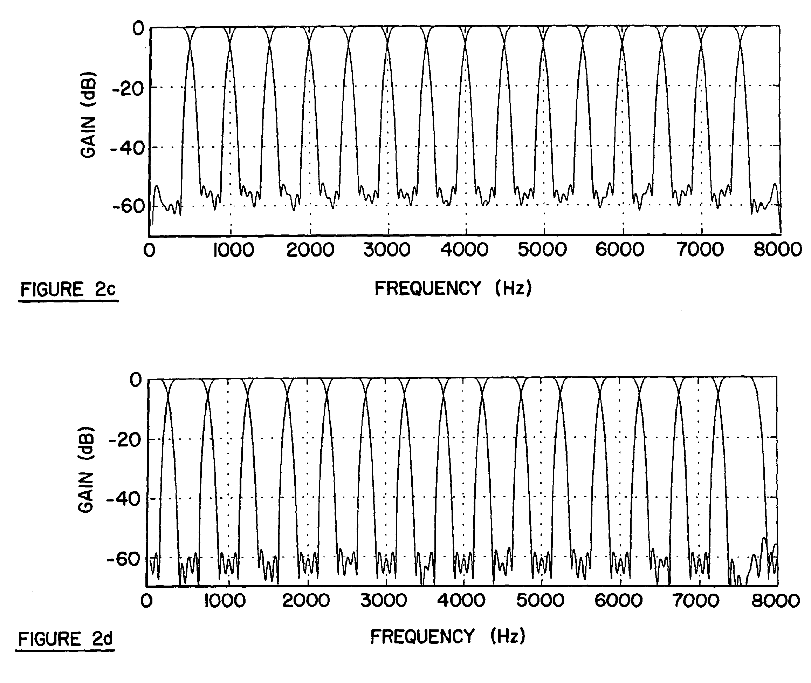

Two types of channel stacking arrangements are known for uniform filterbanks, as shown in Figure 2. For even stacking (Fig. 2a) the n=0 channel is centred at ω=0 and the centres of the bands are at normalized frequencies $\omega_n = \frac{2n\pi}{N}$, n = 0,1, ..., N-1.

Correspondingly, for an odd stacking arrangement (Fig. 2b), the n=0 channel is centred at a ω=π/N and the band frequencies are at $\omega_n = \frac{2n\pi}{N} + \frac{\pi}{N}$, n = 0,1,..., N-1. These even and odd stacking arrangements are shown in Figure 2a and 2b respectively. For audio processing applications, odd stacking is generally preferred over even stacking, because it covers the entire input signal bandwidth between DC and the Nyquist frequency equally with no half bands. The frequency band (DC to sampling rate) in Figure 2a, 2b is shown normalized to cover a span of $2\pi$.

The ability to select either even or odd stacking is a considerable advantage, as it doubles the number of useable band edges. The placement of the band edges is then selectable. The band edges can be selected depending on the characteristics of a person's hearing loss. Figure 2 shows, as a dashed line, a typical input spectrum for 0 to $\pi$ (the normalized Nyquist frequency) that is asymmetric about f=$\pi$ because the signal is sampled at a rate of $2\pi$. Figure 2c and 2d also show the odd and even stacking arrangements. They also show real or characteristic filter responses to each filter.

While the preferred embodiment of the invention has been described, it will be appreciated that many variations are possible within the scope of the invention.

Some types of hearing loss result in precipitous losses or other types of losses which vary significantly across the frequency spectrum, which in turn requires the filterbank gains to vary over a wide dynamic range with respect to each other. In such a case, it becomes advantageous to provide some other frequency dependent gain in a fixed filter before the input to the analysis filterbank 26. This can provide a co-operative arrangement, in which the fixed or prefilter provides a coarse adjustment of the frequency response. This then leaves the analysis filterbank to provide a fine, dynamic adjustment and the problems of widely varying gains between adjacent filter bands are avoided.

The filterbank structure of the present invention provides a natural structure for the generation of pure tones at the centre frequencies of each filter band. As these tones hit a majority of the audiometric frequencies that are employed to measure hearing loss, the filterbank can be programmed to emit pure tones. With these pure tones, the hearing aid can be used directly, to assess hearing loss, replacing the audiometer currently used and making the test more accurate and realistic.

In addition to, or instead of, the prefilter mentioned above, there may be a further requirement for frequency control within a band, which alternatively could be characterised as splitting a band into a number of sub bands. To provide this filtering flexibility, and to maintain the best signal to noise ratio, and to maintain the simple evenly spaced band structure outlined above, a postfilter can be added after the synthesis filterbank 30.

There can be cases involving the fitting of severe losses requiring significant amounts of high frequency gain. In this situation, if the gain is implemented in the filterbanks, the hearing aid can become acoustically unstable. Here, the postfilter would act as a notch filter, to remove only the narrow band of oscillatory frequencies, while leaving the rest of the filter band alone. Alternatively, this can also be accomplished in the filterbank itself.

## Claims

1. A filterbank for filtering an information signal, the filterbank structure comprising a filter means defining a filter bandwidth, said filter means filtering said audio signal and separating said audio signal into a plurality of frequency band signals each representing one of a plurality of uniformly spaced frequency bands within said filter bandwidth, said frequency bands being stacked in an even or odd manner and said frequency bands abutting, overlapping, or being spaced apart from one another, said frequency band signals being downsampled by a decimation factor, **characterized in that**:

    the filter means includes a selection input (46) enabling at least one of the following to be selected:

        (i) the number of frequency band signals,
        (ii) the bandwidth of said frequency bands,
        (iii) whether said frequency bands are stacked in an even or odd manner,
        (iv) whether said frequency bands abut, overlap, or are spaced apart from one another, and
        (v) the decimation factor for downsampling said frequency band signals.

2. A filterbank as claimed in claim 1, wherein the selection input (46) enables at least one of the number of frequency bands and whether said frequency bands are stacked in an even or odd manner to be selected, said number of frequency bands being equal to N, and the filter means comprises:

a) a first analysis filterbank means (26) for separating said signal into the plurality of N separate frequency band signals;
b) processing means (34) for receiving and processing each of said separate frequency band signals to provide N separate processed frequency band signals; and
c) a second synthesis filterbank means (30) for receiving and recombining the N separate processed frequency band signals into a single output signal, wherein both of the first analysis filterbank means (26) and the second synthesis filterbank means (30) are connected to the selection input (46), the processing means (34) being coupled between the first analysis filterbank means (26) and the second synthesis filterbank means (30).

3. A filterbank as claimed in claim 2, which comprises a dedicated application specific integrated circuit (ASIC) (16), said ASIC (16) including the first analysis (26) and the second synthesis filterbanks (30), and a programmable digital signal processor (18) for controlling the number of frequency bands and the bandwidth of each frequency band, said digital signal processor (18) being provided with the selection input (46).

4. A filterbank as claimed in claim 3, wherein said processing means (34) includes a multiplier means (28) for multiplying each of the frequency band signals by an adjustable gain to provide the N separate processed frequency band signals.

5. A filterbank as claimed in claim 4, wherein the first analysis filterbank means (26) includes transform means (68) for transforming the audio signal into the frequency domain, the N separate frequency band signals being present in the frequency domain, and the second synthesis filterbank means (30) includes inverse transform means (82) for transforming the N separate frequency band signals into the single output signal in the time domain.

6. A filterbank as claimed in claim 5, which is adapted to receive a single real monaural information signal, wherein said transform means (68) generates non-negative frequency band signals and negative frequency band signals, said negative frequency band signals being derivable from the non-negative frequency band signals, and said processing means (34) processes only said non-negative frequency band signals.

7. A filterbank as claimed in claim 5, wherein the filterbank is adapted to filter an audio signal comprising first and second real monaural information signals which are combined into a complex stereo signal and wherein said transform means (68) generates N combined frequency band signals, and wherein said processing means (34) includes:

a) channel separation means (76) for separating the N combined frequency band signals into the N frequency band signals corresponding to said first information signal and the N frequency band signals corresponding to said second information signal, each of said N frequency band signals comprising non-negative and negative frequency band signals;
b) first independent channel processing means (70A) connected to the channel separation means (76) for receiving and processing each of said separate frequency band signals of said first information signal to provide a first set of N separate processed frequency band signals;
c) second independent channel processing means (70B) connected to channel separation means (76) for receiving and processing each of said separate frequency band signals of said second information signal to provide a second set of N separate processed frequency band signals; and
d) channel combination means (78) connected to the first (70A) and second independent channel processing means (70B) for combining said first set of N processed separate frequency band signals and said second set of N processed separate frequency band signals.

8. A filterbank as claimed in claim 7, wherein said first (70A) and second independent channel processing means (70B) each process only the non-negative frequency band signals of the corresponding information signal, the negative frequency band signals being derivable from the non-negative frequency band signals.

9. A filterbank as claimed in claim 4, wherein the multiplier means (28) comprises one or more dedicated multiplier resources incorporated on the application specific integrated circuit (16).

10. A filterbank as claimed in claim 4, wherein the multiplier means (28) comprises a multiplier resource provided on the programmable digital signal processor (18).

11. A filterbank as claimed in claim 1, which includes a shared memory interface, for interfacing with a programmable digital signal processor (18).

12. A filterbank as claimed in claim 1, which includes low frequency processing means for additional processing of low-frequency bands to provide additional resolution.

**13.** A filterbank as claimed in claim 2, which includes a prefiltering means connected to the first analysis filterbank means (26), for modifying the gain of at least one selected portion of the frequency spectrum of said information signal.

**14.** A filterbank as claimed in claim 2 or 13, which includes a postfiltering means connected to the second filterbank means (30), for postfiltering the single output signal.

**15.** A filterbank as claimed in claim 3, wherein the first analysis filterbank means (26), the processing means (34) and the second synthesis filterbank means (30) utilize digital signal processing, the first analysis filterbank means (26) being adapted to receive an input digital sample stream and the second synthesis filterbank means (30) providing an output digital data stream as the output signal wherein the filterbank circuit includes an analog-to-digital conversion means (14) connected to said first analysis filterbank (26) for receiving an original analog signal and for converting said analog signal into an input digital sample stream at an initial input sampling rate which forms said information signal for the analysis filterbank (26), and a digital-to-analog conversion means (20) connected to said second synthesis filterbank (30) for converting the output digital data stream to form an analog version of said single output signal.

**16.** A filterbank as claimed in claim 15, wherein the first analysis filterbank means (26) comprises:

a) a blocking means for receiving the input digital sample stream and blocking a first number, R where $R \leq N$, of the digital samples so as to provide a blocked input digital sample stream (50), the ratio of N/R corresponding to an oversampling factor;
b) an analysis window means for applying an analysis window function (60) to the input digital sample stream (50) to provide a windowed blocked digital sample stream (64), said analysis window function (60) being defined by a set of analysis window coefficients;
c) a time folding means (66) for overlapping and adding blocks of said windowed blocked digital sample stream (64), each of said blocks comprising N digital samples, to provide a summed block of N digital samples; and
d) a discrete transform means (68) for receiving said summed block of N digital samples and transforming the signal into a discrete frequency domain signal (74) having N components, the N components corresponding to the N frequency band signals.

**17.** A filterbank as claimed in claim 16, wherein the second synthesis filterbank means (30) comprises:

a) an inverse discrete transform means (82) for receiving said N processed frequency band signals and for effecting an inverse transform to form a block of N digital samples;
b) a replication and concatenation means (84) for replicating and concatenating said processed block of N digital samples to provide a periodically extended block of N digital samples;
c) a synthesis window means for applying a synthesis window function (89) to said extended block of N digital samples to provide a windowed periodically extended block of N digital samples, said synthesis window function (89) being defined by a set of synthesis window coefficients; and
d) a summation buffer means (92) for receiving said windowed periodically extended block of N digital samples and adding said windowed periodically extended samples to the shifted contents of the buffer each time a new windowed periodically extended sample is received, so as to provide a processed information signal.

**18.** A filterbank as claimed in claim 17, wherein said synthesis window function (89) is based on a decimated version of said analysis window function (60).

**19.** A filterbank as claimed in claim 16 or 17, in which the programmable digital signal processor (18) is operable to vary said oversampling factor, and in which the oversampling factor is at least equal to 2.

**20.** A filterbank as claimed in claim 16, 17, or 18 in which the programmable digital signal processor (18) is operable to vary said analysis window coefficients and said synthesis window coefficients.

**21.** A filterbank as claimed in claim 3 in which the programmable digital signal processor (18) is operable to provide either even stacking or odd stacking of the frequency bands within said system bandwidth.

**22.** A filterbank as claimed in claim 1, 2, or 3, in which said filterbank is incorporated in a digital hearing aid.

**23.** An apparatus, for use in a digital hearing aid, **characterized in that** the apparatus comprises:

a dedicated application specific integrated circuit (16), which includes analysis filter means (26) for separating a signal into a plurality of different frequency band signals in different frequency bands and synthesis filter means (30) for recombining the frequency band signals into an output signal;
a programmable digital signal processor (18); and
a multiplication means (28) connected to the programmable digital signal processor (18) and to the application specific integrated circuit (16), wherein the multiplication means (28) multiplies each band by a desired gain, and wherein the gain for each band is controlled by the programmable digital signal processor (18).

24. An apparatus as claimed in claim 23, wherein the multiplication means (28) is provided on the application specific integrated circuit (16).

25. An apparatus as claimed in claim 24, wherein the multiplication means (28) comprises a single multiplier which is shared between the frequency bands.

26. An apparatus as claimed in claim 23, wherein the multiplication means (28) comprises a multiplier-accumulator, which includes a shared memory interface between the application specific integrated circuit (16) and the programmable digital signal processor (18), to provide data transmission between the application specific integrated circuit (16) and the programmable digital signal processor (18).

27. An apparatus as claimed in claim 23, wherein the programmable digital signal processor (18) includes power control means, enabling the programmable digital signal processor to be powered-down between gain calculations to reduce power consumption.

28. An apparatus as claimed in claim 23, wherein the programmable digital signal processor (18) comprises a programmable processor (34), which includes volatile memory (36) for the programmable digital signal processor (34), non-volatile memory (38) and power supply means ensuring reliable reading and writing to the memories.

29. An apparatus as claimed in claim 28, wherein the power supply means comprises a charge pump (40) connected to the non-volatile memory (38) and wherein the power supply means includes means for powering-down the charge pump (40) and the non-volatile memory (38), under software control, after initial startup of the programmable digital signal processor (18) and loading of program and parameter data into the volatile memory (36).

30. An apparatus as claimed in claim 28, which includes sub-band coded audio signals stored in the non-volatile memory (38), which audio signals can be decoded by the synthesis filterbank (30) and the programmable digital signal processor (18), to provide audio signals to a user.

31. An apparatus as claimed in any of claim 23, 26 or 28, which includes:

a microphone (10);
a preamplifier (12) connected to the microphone (10);
an analog-to-digital converter (14) connected to the preamplifier (12) and to an input of the application specific integrated circuit (16), which input is connected to the analysis filter means (26);
a digital-to-analog converter (20) connected to an output of the synthesis filter means (30) of the application specific integrated circuit (16);
a power amplifier (22) connected to the digital-to-analog converter (20); and
a receiver (24) connected to the output of the power amplifier (22).

32. An apparatus as claimed in any of claim 23, 26 or 28, which includes:

a first preamplifier (12) connected to a first input (10);
a second preamplifier (13) connected to a second input (11), at least one of the first and second inputs including a microphone (10);
a first analog-to-digital converter (14) connected to the first preamplifier (12);
a second analog-to-digital converter (15) connected to the second preamplifier (13), each of said first (14) and second analog-to-digital converters (15) being connected to a synchronous serial port (44) on one of the programmable digital signal processor (18) and the application specific integrated circuit (16),
a digital-to-analog converter (20) connected to the same one of the programmable digital signal processor (18) and the application specific integrated circuit (16) as the analog-to-digital converters (14) and (15).
a power amplifier (22) connected to the digital-to-analog converter (20); and
a receiver (24) connected to the output of the power amplifier (22).

33. An apparatus as claimed in claim 23, wherein the analysis filter means (26) comprises a first analysis filterbank means for separating said signal into N separate frequency band signals, and the synthesis filter means (30) comprises a second synthesis filterbank means for receiving and recombining the N separate processed frequency band signals into a single output signal, and wherein the apparatus includes a selection input (46) connected to both of the first analysis filterbank means (26) and the second synthesis filterbank means (30), to enable the number of bands and the band width of each frequency band to be selected.

34. A method of processing an information signal to selectively modify different frequency bands, **characterized in that** the method comprises the steps of:

(1) defining a filter frequency bandwidth to be analyzed;
(2) dividing the filter bandwidth into a plurality of uniformly spaced bands, said frequency bands being stacked in an even or odd manner and said frequency bands abutting, overlapping, or being spaced apart from one another;
(3) filtering the information signal to separate the signal into a plurality of frequency band signals, each representing one of said uniform filter bands, said frequency band signals being downsampled by a decimation factor;
(4) processing the frequency band signals;
(5) recombining the signals of the individual bands to form an output signal; and
(6) providing an input (46) for enabling at least one of the following to be selected:

(i) the number of frequency band signals,
(ii) the bandwidth of said frequency bands,
(iii) whether said frequency bands are stacked in an even or odd manner,
(iv) whether said frequency bands abut, overlap, or are spaced apart from one another, and
(v) the decimation factor for downsampling said frequency band signals.

35. A method as claimed in claim 34, wherein step (4) comprises setting a gain for each frequency band and multiplying each frequency band signal by the respective set gain.

36. A method as claimed in claim 34, the method further comprising:

a) in step (3) separating said signal into N separate frequency band signals;
b) in step (4) processing each of said separate frequency band signals to provide N separate processed frequency band signals;
c) in step (5), recombining the N separate processed frequency band signals to form the output signal; and
d) selecting either the number of frequency bands or whether said frequency bands are stacked in an even or odd manner.

37. A method as claimed in claim 36, which includes transforming the information signal into the frequency domain, providing N separate frequency band signals in the frequency domain, and effecting an inverse transform of the N separate processed frequency band signals into the output signal in the time domain.

38. A method as claimed in claim 37, which comprises generating non-negative frequency band signals and negative frequency band signals, the negative frequency band signals being derivable from the non-negative frequency band signals, and, in step (4), processing only said non-negative frequency band signals.

39. A method as claimed in claim 38, which comprises:

a) receiving an information signal comprising first and second real monaural information signals combined into a complex stereo signal and, when transforming the information signal into the frequency domain, generating N combined frequency band signals;
b) separating the N combined frequency band signals into the N frequency band signals corresponding to said first information signal and the frequency band signals corresponding to said second information signal, each of said N frequency band signals comprising non-negative and negative frequency band signals;
c) processing each of said separate frequency band signals of said first information signal to provide a first set of N separate processed frequency band signals;
d) processing each of said separate frequency band signals of said second information signal to provide a second set of N separate processed frequency band signals; and
e) combining said first set of N processed separate frequency band signals and said second set of N processed separate frequency band signals.

40. A method as claimed in claim 39, which comprises, for each of said first and second information signals processing only the non-negative frequency band signals of the corresponding information signal.

41. A method as claimed in claim 37, wherein the method is effected by digital signal processing, the method including:

passing an original analog signal through an analog-to-digital conversion means (14) to convert the analog signal into an input digital sample stream at an initial input sampling rate which forms said information signal, and wherein the output signal after the inverse transform comprises an output digital data stream; and
effecting a digital to analog conversion (20) of the output digital data stream to form an analog version of the output signal.

42. A method as claimed in claim 41, wherein the step of transforming the information signal into the frequency domain comprises:

a) blocking the input digital sample stream into blocks of R samples, where $R \leq N$, to provide a blocked input digital sample stream, the ratio of N/R corresponding to an oversampling factor;
b) applying an analysis window function (60) to the input digital sample stream to provide a windowed blocked digital sample stream, said analysis window function (60) being defined by a set of analysis window coefficients;
c) overlapping and adding blocks of said windowed blocked digital sample stream, each of said blocks comprising N digital samples, to provide a summed block of N digital samples; and
d) transforming the signal into a discrete frequency domain signal having N components, the N components corresponding to the N frequency band signals.

43. A method as claimed in claim 42, wherein the step of effecting an inverse transform of the N separate processed frequency band signals comprises:

a) effecting an inverse transform to form a block of N digital samples;
b) replicating and concatenating said processed block of N digital samples to provide a periodically extended block of N digital samples;
c) applying a synthesis window function (89) to said extended block of N digital samples to provide a windowed periodically extended block of N digital samples, said synthesis window function (89) being defined by a set of synthesis window coefficients;
d) adding said windowed periodically extended block of N samples to a summation buffer (92); and
e) each time a new windowed periodically extended sample is received, shifting the contents of the summation buffer (92) by R samples from one end of the summation buffer (92) towards the other end of the buffer (92), providing zeros to fill the R empty samples at the one end of the buffer, and passing the R samples displaced out of the other end of the buffer to an output to provide a processed information signal.

44. A method as claimed in claim 43, which includes forming the synthesis window function by decimating the analysis window function (89).

45. A method as claimed in claims 37, 41 or 43, which includes selecting stacking of the frequency bands in one of even stacking and odd stacking, within the frequency bandwidth.

46. A method as claimed in claim 34, which comprises applying the method to an audio information signal in a digital hearing aid

47. A method as claimed in claim 46, including enhancing low-frequency bands by additional processing.

48. A method as claimed in claim 47, which includes subdividing at least one low-frequency band into smaller bands for individual processing.

49. A method as claimed in claim 46, which comprises selecting the number of bands and the width of the bands, in dependence upon acceptable delays and desired resolution.

50. A method as claimed in claim 42 or 43 wherein the oversampling factor can be varied and is at least equal to 2.

51. A method as claimed in claim 43 wherein the analysis window coefficients and the synthesis window coefficients can be varied.

**Patentansprüche**

1. Filterbank zum Filtern eines Informationssignals, wobei die Filterbankstruktur ein Filtermittel, das eine Filterbandbreite definiert, umfasst, wobei das Filtermittel ein Audiosignal filtert und das Audiosignal in eine Vielzahl von Frequenzbandsignalen teilt, von denen jedes eines einer Vielzahl von gleichmäßig beabstandeten Frequenzbändern innerhalb der Filterbandbreite repräsentiert, wobei die Frequenzbänder regelmäßig oder unregelmäßig übereinander angeordnet sind und die Frequenzbänder aneinander anstoßen, sich überlappen oder voneinander beabstandet sind, wobei die Frequenzbandsignale um einen Dezimierungsfaktor abtastreduziert werden, **dadurch gekennzeichnet, dass**:

das Filtermittel einen Auswahleingang (46) umfasst, der die Auswahl von zumindest einem der Folgenden ermöglicht:

(i) die Anzahl der Frequenzbandsignale,
(ii) die Bandbreite der Frequenzbänder,
(iii) ob die Frequenzbänder regelmäßig oder unregelmäßig übereinander angeordnet sind,

(iv) ob die Frequenzbänder aneinander anstoßen, sich überlappen oder voneinander beabstandet sind, und

(v) den Dezimierungsfaktor zur Abtastreduktion der Frequenzbandsignale.

**2.** Filterbank nach Anspruch 1, worin der Auswahleingang (46) die Auswahl von zumindest einem aus der Anzahl der Frequenzbandsignale und ob die Frequenzbänder regelmäßig oder unregelmäßig übereinander angeordnet sind ermöglicht, wobei die Anzahl der Frequenzbänder N entspricht, und das Filtermittel Folgendes umfasst:

a) ein erstes Analysefilterbank-Mittel (26) zum Trennen des Signals in die Vielzahl aus N separaten Frequenzbandsignalen;

b) ein Verarbeitungsmittel (34) zum Empfangen und Verarbeiten eines jeden der separaten Frequenzbandsignale, um N separate verarbeitete Frequenzbandsignale bereitzustellen; und

c) ein zweites Synthesefilterbank-Mittel (30) zum Empfangen und Rekombinieren der N separaten verarbeiteten Frequenzbandsignale zu einem Einfach-Ausgangssignal, worin sowohl das erste Analysefilterbank-Mittel (26) als auch das zweite Synthesefilterbank-Mittel (30) an den Auswahleingang (46) angeschlossen sind und das Verarbeitungsmittel (34) zwischen das erste Analysefilterbank-Mittel (26) und das zweite Synthesefilterbank-Mittel (30) gekoppelt ist.

**3.** Filterbank nach Anspruch 2, umfassend einen zweckbestimmten anwendungsspezifischen integrierten Schaltkreis (ASIC) (16), wobei der ASIC (16) die erste Analysefilterbank (26) und die zweite Synthesefilterbank (30) sowie einen programmierbaren digitalen Signalprozessor (18) zur Steuerung der Anzahl der Frequenzbänder und der Bandbreite eines jeden Frequenzbands umfasst, wobei der digitale Signalprozessor (18) mit dem Auswahleingang (46) ausgestattet ist.

**4.** Filterbank nach Anspruch 3, worin das Verarbeitungsmittel (34) ein Vervielfachungsmittel (28) zum Vervielfachen eines jeden der Frequenzbandsignale um einen einstellbaren Verstärkungsfaktor umfasst, um die N separaten verarbeiteten Frequenzbandsignale bereitzustellen.

**5.** Filterbank nach Anspruch 4, worin das erste Analysefilterbank-Mittel (26) Transformationsmittel (68) zum Transformieren des Audiosignals in den Frequenzbereich umfasst, wobei die N separaten Frequenzbandsignale im Frequenzbereich vorhanden sind, und das zweite Synthesefilterbank-Mittel (30) Rücktransformationsmittel (82) zum Transformieren der N separaten Frequenzbandsignale in das Einfach-Ausgangssignal im Zeitbereich umfasst.

**6.** Filterbank nach Anspruch 5, die geeignet ist, ein einzelnes reelles monaurales Informationssignal zu empfangen, worin das Transformationsmittel (68) nicht-negative Frequenzbandsignale und negative Frequenzbandsignale erzeugt, wobei die negativen Frequenzbandsignale von den nicht-negativen Frequenzbandsignalen ableitbar sind, und das Verarbeitungsmittel (34) ausschließlich die nicht-negativen Frequenzbandsignale verarbeitet.

**7.** Filterbank nach Anspruch 5, worin die Filterbank geeignet ist, ein Audiosignal, das ein erstes und ein zweites reelles monaurales Informationssignal, die zu einem komplexen Stereosignal kombiniert sind, umfasst, zu filtern, worin das Transformationsmittel (68) N kombinierte Frequenzbandsignale erzeugt und worin das Verarbeitungsmittel (34) Folgendes umfasst:

a) ein Kanaltrennungsmittel (76) zum Trennen der N kombinierten Frequenzbandsignale in die N Frequenzbandsignale, die dem ersten Informationssignal entsprechen, und in die N Frequenzbandsignale, die dem zweiten Informationssignal entsprechen, wobei jedes der N Frequenzbandsignale nicht-negative und negative Frequenzbandsignale umfasst;

b) ein erstes unabhängiges Kanalverarbeitungsmittel (70A), das an das Kanaltrennungsmittel (76) angeschlossen ist, um jedes der separaten Frequenzbandsignate des ersten Informationssignals zu empfangen und zu verarbeiten, um einen ersten Satz aus N separaten verarbeiteten Frequenzbandsignalen bereitzustellen;

c) ein zweites unabhängiges Kanalverarbeitungsmittel (70B), das an das Kanaltrennungsmittel (76) angeschlossen ist, um jedes der separaten Frequenzbandsignale des zweiten Informationssignals zu empfangen und zu verarbeiten, um einen zweiten Satz aus N separaten verarbeiteten Frequenzbandsignalen bereitzustellen; und

d) ein Kanalkombinationsmittel (78), das an das erste (70A) und das zweite unabhängige Kanalverarbeitungsmittel (70B) angeschlossen ist, um den ersten Satz aus N verarbeiteten separaten Frequenzbandsignalen und den zweiten Satz aus N verarbeiteten separaten Frequenzbandsignalen zu kombinieren.

**8.** Filterbank nach Anspruch 7, worin das erste (70A) und das zweite unabhängige Kanalverarbeitungsmittel (70B) jeweils nur die nicht-negativen Frequenzbandsignale des entsprechenden Informationssignals verarbeiten, wobei die negativen Frequenzbandsignale von den nicht-negativen Frequenzbandsignalen ableitbar sind.

**9.** Filterbank nach Anspruch 4, worin das Vervielfachungsmittel (28) ein oder mehrere zweckbestimmte Multiplikatorbetriebsmittel umfasst, die im anwendungsspezifischen integrierten Schaltkreis (16) enthalten sind.

**10.** Filterbank nach Anspruch 4, worin das Vervielfachungsmittel (28) ein Multiplikatorbetriebsmittel umfasst, das am programmierbaren digitalen Signalprozessor (18) bereitgestellt ist.

**11.** Filterbank nach Anspruch 1, umfassend eine gemeinsame Speicherschnittstelle, um an einen programmierbaren digitalen Signalprozessor (18) angeschlossen zu sein.

**12.** Filterbank nach Anspruch 1, umfassend niederfrequente Verarbeitungsmittel zum zusätzlichen Verarbeiten von niederfrequenten Bändern, um eine zusätzliche Auflösung bereitzustellen.

**13.** Filterbank nach Anspruch 2, umfassend ein Vorfiltermittel, das an das erste Analysefilterbank-Mittel (26) angeschlossen ist, um den Verstärkungsfaktor von zumindest einem ausgewählten Teilbereich des Frequenzspektrums des Informationssignals zu modifizieren.

**14.** Filterbank nach Anspruch 2 oder 13, umfassend ein Nachfiltermittel, das an das zweite Filterbank-Mittel (30) angeschlossen ist, um das Einfach-Ausgangssignal nachzufiltern.

**15.** Filterbank nach Anspruch 3, worin das erste Analysefilterbank-Mittel (26), das Verarbeitungsmittel (34) und das zweite Synthesefilterbank-Mittel (30) die digitale Signalverarbeitung verwenden, wobei das erste Analysefilterbank-Mittel (26) zum Empfang eines digitalen Eingangs-Abtastwertestroms geeignet ist und das zweite Synthesefilterbank-Mittel (30) einen digitalen Ausgangs-Datenstrom als Ausgangssignal bereitstellt, wobei der Filterbankschaltkreis ein Analog-Digital-Wandlermittel (14) umfasst, das an die erste Analysefilterbank (26) angeschlossen ist, um ein ursprüngliches analoges Signals zu empfangen und das analoge Signal mit einer Anfangseingangs-Abtastrate in einen digitalen Eingangs-Abtastwertestrom umzuwandeln, der das Informationssignal für die Analysefilterbank (26) bildet, sowie ein an die zweite Synthesefilterbank (30) angeschlossenes Digital-Analog-Wandlermittel (20) umfasst, um den digitalen Ausgangs-Datenstrom umzuwandeln, um eine analoge Version des Einfach-Ausgangssignals zu bilden.

**16.** Filterbank nach Anspruch 15, worin das erste Analysefilterbank-Mittel (26) Folgendes umfasst:

a) ein Blockungsmittel zum Empfangen des digitalen Eingangs-Abtastwertestroms und zum Unterteilen einer ersten Anzahl R, worin R ≤ N, der digitalen Abtastwerte in Blöcke, um einen geblockten digitalen Eingangs-Abtastwertestrom (50) bereitzustellen, wobei das Verhältnis N/R einem Überabtastungsfaktor entspricht;
b) ein Analysefenster-Mittel zum Anwenden einer Analysefensterfunktion (60) auf den digitalen Eingangs-Abtastwertestrom (50) um einen mit Fenstern versehenen geblockten digitalen Abtastwertestrom (64) bereitzustellen, wobei die Analysefensterfunktion (60) durch einen Satz aus Analysefensterkoeffizienten definiert ist;
c) ein Zeitfaltungsmittel (66) zum Überlappen und Hinzufügen von Blöcken des mit Fenstern versehenen geblockten digitalen Abtastwertestroms (64), wobei jeder der Blöcke N digitale Abtastwerte umfasst, um einen summierten Block aus N digitalen Abtastwerten bereitzustellen; und
d) ein diskretes Transformationsmittel (68) zum Empfangen des summierten Block aus N digitalen Abtastwerten und zum Transformieren des Signals in ein diskretes Frequenzbereichsignal (74) mit N Komponenten, die den N Frequenzbandsignalen entsprechen.

**17.** Filterbank nach Anspruch 16, worin das zweite Synthesefilterbank-Mittel (30) Folgendes umfasst:

a) ein Rücktransformationsmittel (82) zum Empfangen der N verarbeiteten Frequenzbandsignale und zum Ausführen einer Rücktransformation, um einen Block aus N digitalen Abtastwerten zu bilden;
b) ein Replikations- und Verkettungsmittel (84) zum Replizieren und Verketten des verarbeiteten Blocks aus N digitalen Abtastwerten, um einen periodisch erweiterten Block aus N digitalen Abtastwerten zu bilden;
c) ein Synthesefenster-Mittel zum Anwenden einer Synthesefensterfunktion (89) auf den erweiterten Block aus N digitalen Abtastwerten, um einen mit Fenstern versehenen periodisch erweiterten Block aus N digitalen Abtastwerten bereitzustellen, wobei die Synthesefensterfunktion (89) durch einen Satz aus Synthesefensterkoeffizienten definiert ist;
d) ein Summationspuffermittel (92) zum Empfangen des mit Fenstern versehenen periodisch erweiterten Blocks aus N digitalen Abtastwerten und zum Addieren der mit Fenstern versehenen periodisch erweiterten Abtastwerte mit dem verschobenen Inhalt des Puffers, wann immer ein neues mit Fenstern versehener periodisch erweiterter Abtastwert empfangen wird, um ein verarbeitetes Informationssignal bereitzustellen.

**18.** Filterbank nach Anspruch 17, worin die Synthesefensterfunktion (89) auf einer dezimierten Version der Analysefensterfunktion (60) basiert.

**19.** Filterbank nach Anspruch 16 oder 17, in der der programmierbare digitale Signalprozessor (18) so betrieben werden kann, dass der Überabtastungsfaktor variiert wird, und in der der Überabtastungsfaktor mindestens 2 entspricht.

**20.** Filterbank nach Anspruch 16, 17 oder 18, in der der programmierbare digitale Signalprozessor (18) so betrieben werden kann, dass die Analysefensterkoeffizienten und die Synthesefensterkoeffizienten variiert werden.

**21.** Filterbank nach Anspruch 3, in der der programmierbare digitale Signalprozessor (18) so betrieben werden kann, dass entweder eine regelmäßige Anordnung oder eine unregelmäßige Anordnung der Frequenzbänder innerhalb der Systembandbreite bereitgestellt wird.

**22.** Filterbank nach Anspruch 1, 2 oder 3, in der die Filterbank in einer digitalen Hörhilfe eingebaut ist.

**23.** Vorrichtung zur Verwendung in einer digitalen Hörhilfe, **dadurch gekennzeichnet, dass** die Vorrichtung Folgendes umfasst:

einen zweckbestimmten anwendungsspezifischen integrierten Schaltkreis (16), der ein Analysefiltermittel (26) zum Trennen eines Signals in eine Vielzahl von unterschiedlichen Frequenzbandsignalen in unterschiedliche Frequenzbänder und ein Synthesefiltermittel (30) zum Rekombinieren der Frequenzbandsignale in ein Ausgangssignal umfasst; einen programmierbaren digitalen Signalprozessor (18); und ein Vervielfachungsmittel (28), das an den programmierbaren digitalen Signalprozessor (18) und an den anwendungsspezifischen integrierten Schaltkreis (16) angeschlossen ist, worin das Vervielfachungsmittel (28) jedes Band um einen gewünschten Verstärkungsfaktor vervielfacht und worin der Verstärkungsfaktor für jedes Band durch den programmierbaren digitalen Signalprozessor (18) geregelt ist.

**24.** Vorrichtung nach Anspruch 23, worin das Vervielfachungsmittel (28) auf dem anwendungsspezifischen integrierten Schaltkreis (16) bereitgestellt ist.

**25.** Vorrichtung nach Anspruch 23, worin das Vervielfachungsmittel (28) einen einzelnen Multiplikator umfasst, der von den Frequenzbändern gemeinsam benutzt wird.

**26.** Vorrichtung nach Anspruch 24, worin das Vervielfachungsmittel (28) einen Multiplikator-Akkumulator umfasst, der eine gemeinsame Speicherschnittstelle zwischen dem anwendungsspezifischen integrierten Schaltkreis (16) und dem programmierbaren digitalen Signalprozessor (18) umfasst, um die Datenübertragung zwischen dem anwendungsspezifischen integrierten Schaltkreis (16) und dem programmierbaren digitalen Signalprozessor (18) bereitzustellen.

**27.** Vorrichtung nach Anspruch 23, worin der programmierbare digitale Signalprozessor (18) ein Leistungssteuerungsmittel umfasst, wodurch der programmierbare digitale Signalprozessor (18) zur Senkung des Stromverbrauchs zwischen den Verstärkungsfaktorberechnungen abgeschaltet werden kann.

**28.** Vorrichtung nach Anspruch 23, worin der programmierbare digitale Signalprozessor (18) einen programmierbaren Prozessor (34) umfasst, der einen flüchtigen Speicher (36) für den programmierbaren digitalen Signalprozessor (34), einen nichtflüchtigen Speicher (38) und ein Stromversorgungsmittel, das das verlässliche Lesen der und Schreiben in die Speicher ermöglicht, umfasst.

**29.** Vorrichtung nach Anspruch 28, worin das Stromversorgungsmittel eine Ladepumpe (40) umfasst, die an den nichtflüchtigen Speicher (38) angeschlossen ist, und worin das Stromversorgungsmittel ein durch Software gesteuertes Mittel zum Abschalten der Ladepumpe (40) und des nichtflüchtigen Speichers (38) nach dem anfänglichen Hochfahren des programmierbaren digitalen Signalprozessors (18) und dem Laden der Programm- und Parameterdaten in den flüchtigen Speicher (36) umfasst.

**30.** Vorrichtung nach Anspruch 28, welche mit unterteilten Bändern kodierte Audiosignale, die im nichtflüchtigen Speicher (38) gespeichert sind, umfasst, wobei die Audiosignale von der Synthesefilterbank (30) und dem programmierbaren digitalen Signalprozessor (18) dekodiert werden können, um einem Benutzer Audiosignale bereitzustellen.

**31.** Vorrichtung nach einem der Ansprüche 23, 26 oder 28, umfassend:

ein Mikrophon (10);

einen Vorverstärker (12), der an das Mikrophon (10) angeschlossen ist;

einen Analog-Digital-Wandler (14), der an den Vorverstärker (12) und an einen Eingang des anwendungsspezifischen integrierten Schaltkreises (16) angeschlossen ist, welcher Eingang mit dem Analyse-Filtermittel (26) verbunden ist;

einen Digital-Analog-Wandler (20), der an einen Ausgang des Synthesefiltermittels (30) des anwendungsspezifischen integrierten Schaltkreises (16) angeschlossen ist;

einen Leistungsverstärker (22), der an den Digital-Analog-Wandler (20) angeschlossen ist; und

einen Empfänger (24), der an den Ausgang des Leistungsverstärkers (22) angeschlossen ist.

32. Vorrichtung nach einem der Ansprüche 23, 26 oder 28, umfassend:

einen ersten Vorverstärker (12), der an einen ersten Eingang (10) angeschlossen ist;

einen zweiten Vorverstärker (13), der an einen zweiten Eingang (11) angeschlossen ist, wobei zumindest einer aus dem ersten und dem zweiten Eingang ein Mikrophon (10) umfasst;

einen ersten Analog-Digital-Wandler (14), der an den ersten Vorverstärker (12) angeschlossen ist;

einen zweiten Analog-Digital-Wandler (15), der an den zweiten Vorverstärker (13) angeschlossen ist, wobei der erste (14) und der zweite Analog-Digital-Wandler (15) an eine serielle Synchronschnittstelle (44) an einem aus dem programmierbaren digitalen Signalprozessor (18) und dem anwendungsspezifischen integrierten Schaltkreis (16) angeschlossen sind;

einen Digital-Analog-Wandler (20), der am Gleichen aus dem programmierbaren digitalen Signalprozessor (18) und dem anwendungsspezifischen integrierten Schaltkreis (16) wie die Analog-Digital-Wandler (14) und (15) angeschlossen ist;

einen Leistungsverstärker (22), der an den Digital-Analog-Wandler (20) angeschlossen ist; und

einen Empfänger (24), der an den Ausgang des Leistungsverstärkers (22) angeschlossen ist.

33. Vorrichtung nach Anspruch 23, worin das Analysefiltermittel (26) ein erstes Analysefilterbank-Mittel zum Trennen des Signals in N separate Frequenzbandsignale umfasst und das Synthesefiltermittel (30) ein zweites Synthesefilterbank-Mittel zum Empfangen und Rekombinieren der N separaten verarbeiteten Frequenzbandsignale zu einem Einfach-Ausgangssignal umfasst, und worin die Vorrichtung einen Auswahleingang (46) umfasst, der an das Analysefilterbank-Mittel (26) und an das Synthesefilterbank-Mittel (30) angeschlossen ist, um die Auswahl der Anzahl der Bänder und der Bandbreite eines jeden Frequenzbands zu ermöglichen.

34. Verfahren zur Verarbeitung eines Informationssignals zur selektiven Modifikation unterschiedlicher Frequenzbänder, **dadurch gekennzeichnet, dass** das Verfahren die folgenden Schritte umfasst:

(1) das Definieren einer zu analysierenden Filterfrequenzbandbreite;

(2) das Trennen der Filterbandbreite in eine Vielzahl von gleichmäßig beabstandeten Bändern, wobei die Frequenzbänder regelmäßig oder unregelmäßig übereinander angeordnet sind und die Frequenzbänder aneinander anstoßen, sich überlappen oder voneinander beabstandet sind,

(3) das Filtern des Informationssignals zum Trennen des Signals in eine Vielzahl von Frequenzbandsignalen, von denen jedes eines der gleichmäßigen Filterbänder repräsentiert, wobei die Frequenzbandsignale um einen Dezimierungsfaktor abtastreduziert werden;

(4) das Verarbeiten der Frequenzbandsignale;

(5) das Rekombinieren der Signale der einzelnen Bänder, um ein Ausgangssignal zu bilden; und

(6) das Bereitstellen einer Eingabe (46), um die Auswahl von zumindest einem der Folgenden zu ermöglichen:

(i) die Anzahl der Frequenzbändsignale,

(ii) die Bandbreite der Frequenzbänder,

(iii) ob die Frequenzbänder regelmäßig oder unregelmäßig übereinander angeordnet sind,

(iv) ob die Frequenzbänder aneinander anstoßen, sich überlappen oder voneinander beabstandet sind, und

(v) den Dezimierungsfaktor zur Abtastreduktion der Frequenzbandsignale.

35. Verfahren nach Anspruch 34, worin Schritt (4) das Festlegen eines Verstärkungsfaktors für jedes Frequenzband und das Vervielfachen eines jeden Frequenzbandsignals um den entsprechenden festgelegten Verstärkungsfaktor umfasst.

36. Verfahren nach Anspruch 34, wobei das Verfahren zudem Folgendes umfasst:

a) das Trennen des Signals in N separate Frequenzbandsignale in Schritt (3);

b) das Verarbeiten eines jeden der separaten Frequenzbandsignale, um N separate verarbeitete Frequenzbandsignale bereitzustellen, in Schritt (4);

c) das Rekombinieren der N separaten verarbeiteten Frequenzbandsignale, um das Ausgangssignal zu bilden, in Schritt (5); und

d) das Auswählen der Anzahl der Frequenzbänder oder das Auswählen, ob die Frequenzbänder regelmäßig oder unregelmäßig übereinander angeordnet sind.

37. Verfahren nach Anspruch 36, umfassend die Transformation des Informationssignals in den Frequenzbereich, das Bereitstellen von N separaten Frequenzbandsignalen im Frequenzbereich und das Ausführen einer Rücktransformation der N separaten verarbeiteten Frequenzbandsignale in das Ausgangssignal im Zeitbereich.

38. Verfahren nach Anspruch 37, umfassend das Erzeugen von nicht-negativen Frequenzbandsignalen und von negativen Frequenzbandsignalen, wobei die negativen Frequenzbandsignale von den nicht-negativen Frequenzbandsignalen ableitbar sind, und, in Schritt (4), das ausschließliche Verarbeiten der nicht-negativen Frequenzbandsignale.

39. Verfahren nach Anspruch 38, umfassend:

a) das Empfangen eines Informationssignals, umfassend ein erstes und ein zweites reelles monaurales Informationssignal, die zu einen komplexen Stereosignal kombiniert sind, und das Erzeugen von N kombinierten Frequenzbandsignalen bei der Transformation des Informationssignals in den Frequenzbereich;

b) das Trennen der N kombinierten Frequenzbandsignale in die N Frequenzbandsignale, die dem ersten Informationssignal entsprechen, und in die N Frequenzbandsignale, die dem zweiten Informationssignal entsprechen, wobei jedes der N Frequenzbandsignale nicht-negative und negative Frequenzbandsignale umfasst;

c) das Verarbeiten eines jeden der separaten Frequenzbandsignale des ersten Informationssignals, um einen ersten Satz aus N separaten verarbeiteten Frequenzbandsignalen bereitzustellen;

d) das Verarbeiten eines jeden der separaten Frequenzbandsignale des zweiten Informationssignals, um einen zweiten Satz aus N separaten verarbeiteten Frequenzbandsignalen bereitzustellen; und

e) das Kombinieren des ersten Satzes aus N separaten verarbeiteten Frequenzbandsignalen und des zweiten Satzes aus N separaten verarbeiteten Frequenzbandsignalen.

40. Verfahren nach Anspruch 39, das für das erste und das zweite Informationssignal die ausschließliche Verarbeitung der nicht-negativen Frequenzbandsignale des entsprechenden Informationssignals umfasst.

41. Verfahren nach Anspruch 37, worin das Verfahren durch digitale Signalverarbeitung ausgeführt wird und das Verfahren Folgendes umfasst:

das Durchschicken eines ursprünglichen analogen Signals durch ein Analog-Digital-Wandlermittel (14); um das analoge Signal mit einer Anfangseingangs-Abtastrate in einen digitalen Eingangs-Abtastwertestrom umzuwandeln, der das Informationssignal bildet, und worin das Ausgangssignal nach der Rücktransformation einen digitalen Ausgangs-Datenstrom umfasst; und

das Ausführen einer Digital-Analog-Wandlung (20) des digitalen Ausgangs-Datenstroms, um eine analoge Version des Ausgangssignals zu bilden.

42. Verfahren nach Anspruch 41, worin der Schritt der Transformation des Informationssignals in den Frequenzbereich Folgendes umfasst:

a) das Unterteilen des digitalen Eingangs-Abtastwertestroms in Blöcke von R Abtastwerten, worin $R \leq N$, um einen geblockten digitalen Eingangs-Abtastwertestrom bereitzustellen, wobei das Verhältnis N/R einem Überabtastungsfaktor entspricht;

b) das Anwenden einer Analysefensterfunktion (60) auf den digitalen Eingangs-Abtastwertestrom (50), um einen mit Fenstern versehenen geblockten digitalen Abtastwertestrom (64) bereitzustellen, wobei die Analysefensterfunktion (60) durch einen Satz aus Analysefensterkoeffizienten definiert ist;

c) das Überlappen und Hinzufügen von Blöcken des mit Fenstern versehenen geblockten digitalen Abtastwertestroms, wobei jeder der Blöcke N digitale Abtastwerte umfasst, um einen summierten Block aus N digitalen Abtastwerten bereitzustellen; und

d) das Transformieren des Signals in ein diskretes Frequenzbereichsignal mit N Komponenten, wobei die N Komponenten den N Frequenzbandsignalen entsprechen.

43. Verfahren nach Anspruch 42, worin der Schritt des Ausführens der Rücktransformation der N separaten verarbeiteten Frequenzbandsignale Folgendes umfasst:

a) das Ausführen einer Rücktransformation, um einen Block aus N digitalen Abtastwerten zu bilden;

b) das Replizieren und Verketten des verarbeiteten Blocks aus N digitalen Abtastwerten, um einen periodisch erweiterten Block aus N digitalen Abtastwerten zu bilden;

c) das Anwenden einer Synthesefensterfunktion (89) auf den erweiterten Block aus N digitalen Abtastwerten, um einen mit Fenstern versehenen periodisch erweiterten Block aus N digitalen Abtastwerten bereitzustellen, wobei die Synthesefensterfunktion (89) durch einen Satz aus Synthesefensterkoeffizienten definiert ist;

d) das Addieren des mit Fenstern versehenen periodisch erweiterten Blocks aus N Abtastwerten mit einem Summationspuffer (92); und

e) das Verschieben des Inhalts des Summationspuffers (92), wann immer ein neuer mit Fenstern versehener periodisch erweiterter Abtastwert empfangen wird, von einem Ende des Summationspuffers (92) um R Abtastwerte zum anderen Ende des Summationspuffers (92) hin, das Bereitstellen von Nullen zum Füllen der R leeren Abtastwerte am einen Ende des Puffers und das Schikken der R verschobenen Abtastwerte aus dem anderen Ende des Puffers hinaus zu einem Ausgang, um ein verarbeitetes Informationssignal bereitzustellen.

**44.** Verfahren nach Anspruch 43, umfassend das Bilden der Synthesefensterfunktion durch Dezimieren der Analysefensterfunktion (89).

**45.** Verfahren nach Anspruch 37, 41 oder 43, umfassend das Auswählen der Anordnung der Frequenzbänder innerhalb der Frequenzbandbreite zu einem aus regelmäßiger Anordnung und unregelmäßiger Anordnung.

**46.** Verfahren nach Anspruch 34, umfassend das Anwenden des Verfahrens auf ein Audioinformationssignal in einer digitalen Hörhilfe.

**47.** Verfahren nach Anspruch 46, umfassend das Verstärken der niederfrequenten Bänder durch zusätzliche Verarbeitung.

**48.** Verfahren nach Anspruch 47, umfassend das Unterteilen von zumindest einem niederfrequenten Band in kleinere Bänder zur einzelnen Verarbeitung.

**49.** Verfahren nach Anspruch 46, umfassend das Auswählen der Anzahl der Bänder und der Breite der Bänder in Abhängigkeit von annehmbaren Verzögerungen und der gewünschten Auflösung.

**50.** Verfahren nach Anspruch 42 oder 43, worin der Überabtastungsfaktor variiert werden kann und mindestens 2 beträgt.

**51.** Verfahren nach Anspruch 43, worin die Analysefensterkoeffizienten und die Synthesefensterkoeffizienten variiert werden können.

## Revendications

**1.** Banc de filtres pour filtrer un signal d'information, la structure de banc de filtres comprenant un moyen de filtre définissant une largeur de bande de filtre, ledit moyen de filtre filtrant ledit signal audio et séparant ledit signal audio en une pluralité de signaux de bande de fréquence représentant chacun l'une parmi une pluralité de bandes de fréquence uniformément espacées dans ladite largeur de bande de filtre, lesdites bandes de fréquence étant empilées d'une manière régulière ou irrégulière et lesdites bandes de fréquence étant en butée, se chevauchant ou étant espacées les unes par rapport aux autres, lesdits signaux de bande de fréquence étant sous-échantillonnés d'un facteur de décimation, **caractérisé en ce que** :

le moyen de filtre comprend une entrée de sélection (46) permettant qu'au moins l'un des suivants soit sélectionné :

(i) le nombre de signaux de bande de fréquence,

(ii) la largeur de bande desdites bandes de fréquence,

(iii) que lesdites bandes de fréquence soient empilées d'une manière régulière ou irrégulière,

(iv) que lesdites bandes de fréquence soient en butée, se chevauchent ou soient espacées les unes par rapport aux autres, et

(v) le facteur de décimation pour sous-échantillonner lesdits signaux de bande de fréquence.

**2.** Banc de filtres selon la revendication 1, dans lequel l'entrée de sélection (46) permet qu'au moins l'une parmi le nombre de bandes de fréquence et que lesdites bandes de fréquence soient empilées de manière régulière ou irrégulière soit sélectionné, ledit nombre de bandes de fréquence étant égal à N, et le moyen de filtre comprend :

a) un premier moyen de banc de filtres d'analyse (26) pour séparer ledit signal en la pluralité de N signaux de bande de fréquence séparés ;

b) un moyen de traitement (34) pour recevoir et traiter chacun desdits signaux de bande de fréquence séparés pour générer N signaux de bande de fréquence traités séparés ; et

c) un second moyen de banc de filtres de synthèse (30) pour recevoir et recombiner les N signaux de bande de fréquence traités séparés en un signal de sortie unique, dans lequel le premier moyen de banc de filtres d'analyse (26) et le second moyen de banc de filtres de synthèse (30) sont connectés à l'entrée de sélection (46), le moyen de traitement (34) étant couplé entre le premier moyen de banc de filtres d'analyse (26) et le second moyen de banc de filtres de synthèse (30).

3. Banc de filtres selon la revendication 2, qui comprend un circuit intégré à application spécifique (ASIC) dédié (16), ledit ASIC (16) comprenant le premier banc de filtres d'analyse (26) et le second banc de filtres de synthèse (30), et un processeur de signal numérique programmable (18) pour contrôler le nombre de bandes de fréquence et la largeur de bande de chaque bande de fréquence, ledit processeur de signal numérique (18) étant pourvu de l'entrée de sélection (46).

4. Banc de filtres selon la revendication 3, dans lequel ledit moyen de traitement (34) comprend un moyen multiplicateur (28) pour multiplier chacun des signaux de bande de fréquence par un gain ajustable pour générer les N signaux de bande de fréquence traités séparés.

5. Banc de filtres selon la revendication 4, dans lequel le premier moyen de banc de filtres d'analyse (26) comprend un moyen de transformée (68) pour transformer le signal audio en domaine de fréquence, les N signaux de bande de fréquence séparés étant présents dans le domaine de fréquence, et le second moyen de banc de filtres de synthèse (30) comprend un moyen de transformée inverse (82) pour transformer les N signaux de bande de fréquence séparés en le signal de sortie unique dans le domaine temporel.

6. Banc de filtres selon la revendication 5, qui est adapté pour recevoir un signal d'information monaural réel unique, dans lequel ledit moyen de transformée (68) génère des signaux de bande de fréquence non négatifs et des signaux de bande de fréquence négatifs, lesdits signaux de bande de fréquence négatifs étant dérivables à partir des signaux de bande de fréquence non négatifs, et ledit moyen de traitement (34) traite uniquement lesdits signaux de bande de fréquence non négatifs.

7. Banc de filtres selon la revendication 5, dans lequel le banc de filtres est adapté pour filtrer un signal audio comprenant des premier et second signaux d'information monauraux réels qui sont combinés en un signal stéréo complexe et dans lequel dans lequel ledit moyen de transformée (68) génère N signaux de bande de fréquence combinés, et dans lequel ledit moyen de traitement (34) comprend :

   a) un moyen de séparation de canal (76) pour séparer les N signaux de bande de fréquence combinés en les N signaux de bande de fréquence correspondant audit premier signal d'information et les N signaux de bande de fréquence correspondant audit second signal d'information, chacun desdits N signaux de bande de fréquence comprenant des signaux de bande de fréquence non négatifs et négatifs ;
   b) un premier moyen de traitement de canal indépendant (70A) connecté au moyen de séparation de canal (76) pour recevoir et traiter chacun desdits signaux de bande de fréquence séparés dudit premier signal d'information pour générer un premier jeu de N signaux de bande de fréquence traités séparés ;
   c) un second moyen de traitement de canal indépendant (70B) connecté au moyen de séparation de canal (76) pour recevoir et traiter chacun desdits signaux de bande de fréquence séparés dudit second signal d'information pour générer un second jeu de N signaux de bande de fréquence traités séparés ; et
   d) un moyen de combinaison de canal (78) connecté aux premier (70A) et second (70B) moyens de traitement de canal indépendants pour combiner ledit premier jeu de N signaux de bande de fréquence traités séparés et ledit second jeu de signaux de bande de fréquence traités séparés.

8. Banc de filtres selon la revendication 7, dans lequel lesdits premier (70A) et second (70B) moyens de traitement de canal indépendants traitent chacun uniquement les signaux de bande de fréquence non négatifs du signal d'information correspondant, les signaux de bande de fréquence négatifs étant dérivables à partir des signaux de bande de fréquence non négatifs.

9. Banc de filtres selon la revendication 4, dans lequel le moyen multiplicateur (28) comprend une ou plusieurs ressources multiplicatrices dédiées incorporées sur le circuit intégré à application spécifique (16).

10. Banc de filtres selon la revendication 4, dans lequel le moyen multiplicateur (28) comprend une ressource multiplicatrice disposée sur le processeur de signal numérique programmable (18).

11. Banc de filtres selon la revendication 1, qui comprend une interface de mémoire partagée, pour interfaçage avec un processeur de signal numérique programmable (18).

**12.** Banc de filtres selon la revendication 1, qui comprend un moyen de traitement de basse fréquence pour le traitement supplémentaire des bandes à basse fréquence pour produire une résolution supplémentaire.

**13.** Banc de filtres selon la revendication 2, qui comprend un moyen de préfiltrage connecté au premier moyen de banc de filtres d'analyse (26), pour modifier le gain d'au moins une partie sélectionnée du spectre de fréquence dudit signal d'information.

**14.** Banc de filtres selon la revendication 2 ou 13, qui comprend un moyen de post-filtrage connecté au second moyen de banc de filtres (30), pour post-filtrer le signal de sortie unique.

**15.** Banc de filtres selon la revendication 3, dans lequel le premier moyen de banc de filtres d'analyse (26), le moyen de traitement (34) et le second moyen de banc de filtres de synthèse (30) utilisent un traitement de signal numérique, le premier moyen de banc de filtres d'analyse (26) étant adapté pour recevoir un train d'échantillon numérique d'entrée et le second moyen de banc de filtres de synthèse (30) émettant un train de données numériques de sortie en tant que signal de sortie dans lequel le circuit de banc de filtres comprend un moyen de conversion analogique-numérique (14) connecté audit premier banc de filtres d'analyse (26) pour recevoir un signal analogique original et pour convertir ledit signal analogique en un train d'échantillon numérique d'entrée à une fréquence d'échantillonnage d'entrée initiale qui forme ledit signal d'information pour le banc de filtres d'analyse (26) et un moyen de conversion numérique-analogique (20) connecté audit second banc de filtres de synthèse (30) pour convertir le train de données numériques de sortie pour former une version analogique dudit signal de sortie unique.

**16.** Banc de filtres selon la revendication 15, dans lequel le premier moyen de banc de filtres d'analyse (26) comprend :

a) un moyen de blocage pour recevoir le train d'échantillon numérique d'entrée et bloquer un premier nombre, R, où R ≤ N, des échantillons numériques de manière à générer un train d'échantillon numérique d'entrée bloqué (50), le rapport N/R correspondant à un facteur de suréchantillonnage ;
b) un moyen de fenêtre d'analyse pour appliquer une fonction de fenêtre d'analyse (60) au train d'échantillon numérique d'entrée (50) pour générer un train d'échantillon numérique bloqué fenêtré (64), ladite fonction de fenêtre d'analyse (60) étant définie par un jeu de coefficients de fenêtre d'analyse ;

c) un moyen de pliage temporel (66) pour superposer et additionner des blocs dudit train d'échantillon numérique bloqué fenêtré (64), chacun desdits blocs comprenant N échantillons numériques, pour générer un bloc sommé de N échantillons numériques ; et
d) un moyen de transformée discrète (68) pour recevoir ledit bloc sommé de N échantillons numériques et transformer le signal en un signal de domaine de fréquence discret (74) ayant N composantes, les N composantes correspondant aux N signaux de bande de fréquence.

**17.** Banc de filtres selon la revendication 16, dans lequel le second moyen de banc de filtres de synthèse (30) comprend :

a) un moyen de transformée discrète inverse (82) pour recevoir lesdits N signaux de bande de fréquence traités et pour effectuer une transformée inverse pour former un bloc de N échantillons numériques ;
b) un moyen de réplication et de concaténation (84) pour répliquer et concaténer ledit bloc traité de N échantillons numériques pour générer un bloc périodiquement étendu de N échantillons numériques ;
c) un moyen de fenêtre de synthèse pour appliquer une fonction de fenêtre de synthèse (89) audit bloc étendu de N échantillons numériques pour générer un bloc périodiquement étendu fenêtré de N échantillons numériques, ladite fonction de fenêtre de synthèse (89) étant définie par un jeu de coefficients de fenêtre de synthèse ; et
d) un moyen de tampon de sommation (92) pour recevoir ledit bloc périodiquement étendu fenêtré de N échantillons numériques et additionner lesdits échantillons périodiquement étendus fenêtrés au contenu décalé du tampon chaque fois qu'un nouvel échantillon périodiquement étendu fenêtré est reçu, de manière à générer un signal d'information traité.

**18.** Banc de filtres selon la revendication 17, dans lequel ladite fonction de fenêtre de synthèse (89) est basée sur une version décimée de ladite fonction de fenêtre d'analyse (60).

**19.** Banc de filtres selon la revendication 16 ou 17, dans laquelle le processeur de signal numérique programmable (18) est opérationnel pour faire varier ledit facteur de suréchantillonnage, et dans lequel le facteur de suréchantillonnage est égal à au moins 2.

**20.** Banc de filtres selon la revendication 16, 17 ou 18 dans lequel le processeur de signal numérique programmable (18) est opérationnel pour faire varier lesdits coefficients de fenêtre d'analyse et lesdits coefficients de fenêtre de synthèse.

21. Banc de filtres selon la revendication 3 dans lequel le processeur de signal numérique programmable (18) est opérationnel pour produire un empilage régulier ou un empilage irrégulier des bandes de fréquence dans ladite largeur de bande du système.

22. Banc de filtres selon la revendication 1, 2 ou 3, dans lequel ledit banc de filtres est incorporé dans une prothèse auditive numérique.

23. Appareil, pour utilisation dans une prothèse auditive numérique, **caractérisé en ce que** l'appareil comprend :

> un circuit intégré à application spécifique dédié (16), qui comprend un moyen de filtre d'analyse (26) pour séparer un signal en une pluralité de signaux de bande de fréquence différents dans différentes bandes de fréquence et un moyen de filtre de synthèse (30) pour recombiner les signaux de bande de fréquence en un signal de sortie ;
> un processeur de signal numérique programmable (18) ; et
> un moyen de multiplication (28) connecté au processeur de signal numérique programmable (18) et au circuit intégré à application spécifique (16), dans lequel le moyen de multiplication (28) multiplie chaque bande par un gain souhaité, et dans lequel le gain pour chaque bande est contrôlé par le processeur de signal numérique programmable (18) .

24. Appareil selon la revendication 23, dans lequel le moyen de multiplication (28) est disposé sur le circuit intégré à application spécifique (16).

25. Appareil selon la revendication 24, dans lequel le moyen de multiplication (28) comprend un multiplicateur unique qui est partagé entre les bandes de fréquence.

26. Appareil selon la revendication 23, dans lequel le moyen de multiplication (28) comprend un multiplicateur-accumulateur, qui comprend une interface de mémoire partagée entre le circuit intégré à application spécifique (16) et le processeur de signal numérique programmable (18), pour effectuer la transmission de données entre le circuit intégré à application spécifique (16) et le processeur de signal numérique programmable (18).

27. Appareil selon la revendication 23, dans lequel le processeur de signal numérique programmable (18) comprend un moyen de contrôle de puissance, permettant au processeur de signal numérique programmable d'être mis hors tension entre les calculs de gain afin de réduire la consommation d'énergie.

28. Appareil selon la revendication 23, dans lequel le processeur de signal numérique programmable (18) comprend un processeur programmable (34), qui comprend une mémoire volatile (36) pour le processeur de signal numérique programmable (34), une mémoire non volatile (38) et un moyen d'alimentation assurant une lecture et une écriture fiables dans les mémoires.

29. Appareil selon la revendication 28, dans lequel le moyen d'alimentation comprend une pompe de charge (40) connectée à la mémoire non volatile (38) et dans lequel le moyen d'alimentation comprend un moyen pour mettre hors tension la pompe de charge (40) et la mémoire non volatile (38), sous contrôle logiciel, après le démarrage initial du processeur de signal numérique programmable (18) et le chargement du programme et des données de paramètre dans la mémoire volatile (36).

30. Appareil selon la revendication 28, qui comprend des signaux audio codés de sous-bande stockés dans la mémoire non volatile (38), signaux audio qui peuvent être décodés par le banc de filtres de synthèse (30) et le processeur de signal numérique programmable (18), pour transmettre des signaux audio à un utilisateur.

31. Appareil selon l'une quelconque des revendications 23, 26 ou 28, qui comprend :

> un microphone (10) ;
> un préamplificateur (12) connecté au microphone (10) ;
> un convertisseur analogique-numérique (14) connecté au préamplificateur (12) et à une entrée du circuit intégré à application spécifique (16), entrée qui est connectée au moyen de filtre d'analyse (26) ;
> un convertisseur numérique-analogique (20) connecté à une sortie du moyen de filtre de synthèse (30) du circuit intégré à application spécifique (16) ;
> un amplificateur de puissance (22) connecté au convertisseur numérique-analogique (20) ; et
> un récepteur (24) connecté à la sortie de l'amplificateur de puissance (22).

32. Appareil selon l'une quelconque des revendications 23, 26 ou 28, qui comprend :

> un premier préamplificateur (12) connecté à une première entrée (10) ;
> un deuxième préamplificateur (13) connecté à une deuxième entrée (11), au moins l'une des première et deuxième entrées comprenant un microphone (10) ;

un premier convertisseur analogique-numérique (14) connecté au premier préamplificateur (12) ;

un deuxième convertisseur analogique-numérique (15) connecté au deuxième préamplificateur (13), chacun desdits premier (14) et deuxième (15) convertisseurs analogique-numérique étant connecté à un port série synchrone (44) sur l'un parmi le processeur de signal numérique programmable (18) et le circuit intégré à application spécifique (16),

un convertisseur numérique-analogique (20) connecté au même parmi le processeur de signal numérique programmable (18) et le circuit intégré à application spécifique (16) que les convertisseurs analogique-numérique (14) et (15) ;

un amplificateur de puissance (22) connecté au convertisseur numérique-analogique (20) ; et un récepteur connecté à la sortie de l'amplificateur de puissance (22).

33. Appareil selon la revendication 23, dans lequel le moyen de filtre d'analyse (26) comprend un premier moyen de banc de filtres d'analyse pour séparer ledit signal en N signaux de bande de fréquence séparés, et le moyen de banc de filtres de synthèse (30) comprend un second moyen de banc de filtres de synthèse pour recevoir et recombiner les N signaux de bande de fréquence traités séparés en un signal de sortie unique, et dans lequel l'appareil comprend une entrée de sélection (46) connectée au premier moyen de banc de filtres d'analyse (26) et au second moyen de banc de filtres de synthèse (30), pour permettre que le nombre de bandes et la largeur de bande de chaque bande de fréquence soient sélectionnés.

34. Procédé de traitement d'un signal d'information pour modifier sélectivement différentes bandes de fréquence, **caractérisé en ce que** le procédé comprend les étapes de :

(1) définition d'une largeur de bande de fréquence de filtre à analyser ;

(2) division de la largeur de bande de filtre en une pluralité de bandes uniformément espacées, lesdites bandes de fréquence étant empilées d'une manière régulière ou irrégulière et lesdites bandes de fréquence étant en butée, se chevauchant ou étant espacées les unes par rapport aux autres ;

(3) filtrage du signal d'information pour séparer le signal en une pluralité de signaux de bande de fréquence, représentant chacun l'une desdites bandes de filtre uniformes, lesdits signaux de bande de fréquence étant sous-échantillonnés d'un facteur de décimation ;

(4) traitement des signaux de bande de fréquence ;

(5) recombinaison des signaux des bandes individuelles pour former un signal de sortie ; et

(6) génération d'une entrée (46) pour permettre qu'au moins l'un des suivants soit sélectionné :

(i) le nombre de signaux de bande de fréquence,

(ii) la largeur de bande desdites bandes de fréquence,

(iii) que lesdites bandes de fréquence soient empilées d'une manière régulière ou irrégulière,

(iv) que lesdites bandes de fréquence soient en butée, se chevauchent ou soient espacées les unes des autres, et

(v) le facteur de décimation pour sous-échantillonner lesdits signaux de bande de fréquence.

35. Procédé selon la revendication 34, dans lequel l'étape (4) comprend la définition d'un gain pour chaque bande de fréquence et la multiplication de chaque signal de bande de fréquence par le gain défini respectif.

36. Procédé selon la revendication 34, le procédé comprenant en outre :

a) dans l'étape (3), la séparation dudit signal en N signaux de bande de fréquence séparés ;

b) dans l'étape (4), le traitement de chacun desdits signaux de bande de fréquence séparés pour générer N signaux de bande de fréquence traités séparés ;

c) dans l'étape (5), la recombinaison des N signaux de bande de fréquence traités séparés pour former le signal de sortie ; et

d) la sélection du nombre de bandes de fréquence ou que lesdits bandes de fréquence soient empilées d'une manière régulière ou irrégulière.

37. Procédé selon la revendication 36, qui comprend la transformation du signal d'information en domaine de fréquence, en générant N signaux de bande de fréquence séparés dans le domaine de fréquence, et la conduite d'une transformée inverse des N signaux de bande de fréquence traités séparés en le signal de sortie dans le domaine temporel.

38. Procédé selon la revendication 37, qui comprend la génération de signaux de bande de fréquence non négatifs et de signaux de bande de fréquence négatifs, les signaux de bande de fréquence négatifs étant dérivables à partir des signaux de bande de fréquence non négatifs, et, dans l'étape (4), le traitement uniquement desdits signaux de bande de fréquence non négatifs.

**39.** Procédé selon la revendication 38, qui comprend :

a) la réception d'un signal d'information comprenant des premier et deuxième signaux d'information monauraux réels combinés en un signal stéréo complexe et, lors de la transformation du signal d'information en domaine de fréquence, la génération de N signaux de bande de fréquence combinés ;

b) la séparation des N signaux de bande de fréquence combinés en les N signaux de bande de fréquence correspondant audit premier signal d'information et les signaux de bande de fréquence correspondant audit deuxième signal d'information chacun desdits N signaux de bande de fréquence comprenant des signaux de bande de fréquence non négatifs et négatifs ;

c) le traitement de chacun desdits signaux de bande de fréquence séparés dudit premier signal d'information pour générer un premier jeu de N signaux de bande de fréquence traités séparés ;

d) le traitement de chacun desdits signaux de bande de fréquence séparés dudit deuxième signal d'information pour générer un deuxième jeu de N signaux de bande de fréquence traités séparés ; et

e) la combinaison dudit premier jeu de N signaux de bande de fréquence traités séparés et dudit deuxième jeu de N signaux de bande de fréquence traités séparés.

**40.** Procédé selon la revendication 39, qui comprend, pour chacun desdits premier et deuxième signaux d'information, le traitement uniquement des signaux de bande de fréquence non négatifs du signal d'information correspondant.

**41.** Procédé selon la revendication 37, dans lequel le procédé est conduit par traitement de signal numérique, le procédé comprenant :

le passage d'un signal analogique original à travers un moyen de conversion analogique-numérique (14) pour convertir le signal analogique en un train d'échantillon numérique d'entrée à une fréquence d'échantillonnage d'entrée initiale qui forme ledit signal d'information, et dans lequel le signal de sortie après la transformée inverse comprend un train de données numériques de sortie ; et

la conduite d'une conversion numérique-analogique (20) du train de données numériques de sortie pour former une version analogique du signal de sortie.

**42.** Procédé selon la revendication 41, dans lequel l'étape de transformation du signal d'information en domaine de fréquence comprend :

a) le blocage du train d'échantillon numérique d'entrée en blocs de R échantillons, où R ≤ N, pour générer un train d'échantillon numérique d'entrée bloqué, le rapport N/R correspondant à un facteur de suréchantillonnage ;

b) l'application d'une fonction de fenêtre d'analyse (60) au train d'échantillon numérique d'entrée pour générer un train d'échantillon numérique bloqué fenêtré, ladite fonction de fenêtre d'analyse (60) étant définie par un jeu de coefficients de fenêtre d'analyse ;

c) la superposition et l'ajout de blocs dudit train d'échantillon numérique bloqué fenêtré, chacun desdits blocs comprenant N échantillons numériques, pour générer un bloc sommé de N échantillons numériques ; et

d) la transformation du signal en un signal de domaine de fréquence discret ayant N composantes, les N composantes correspondant aux N signaux de bande de fréquence.

**43.** Procédé selon la revendication 42, dans lequel l'étape de conduite d'une transformée inverse des N signaux de bande de fréquence traités séparés comprend :

a) la conduite d'une transformée inverse pour former un bloc de N échantillons numériques ;

b) la réplication et la concaténation dudit bloc traité de N échantillons numériques pour générer un bloc périodiquement étendu de N échantillons numériques ;

c) l'application d'une fonction de fenêtre de synthèse (89) audit bloc étendu de N échantillons numériques pour générer un bloc périodiquement étendu fenêtré de N échantillons numériques, ladite fonction de fenêtre de synthèse (89) étant définie par un jeu de coefficients de fenêtre de synthèse ;

d) l'ajout dudit bloc périodiquement étendu fenêtré de N échantillons à un tampon de sommation (92) ; et

e) chaque fois qu'un nouvel échantillon périodiquement étendu fenêtré est reçu, le décalage du contenu du tampon de sommation (92) de R échantillons depuis une extrémité du tampon de sommation (92) vers l'autre extrémité du tampon (92), en disposant des zéros pour remplir les R échantillons vides à la première extrémité du tampon, et le passage des R échantillons déplacés hors de l'autre extrémité du tampon vers une sortie pour générer un signal d'information traité.

**44.** Procédé selon la revendication 43, qui comprend la formation de la fonction de fenêtre de synthèse par décimation de la fonction de fenêtre d'analyse (89).

**45.** Procédé selon les revendications 37, 41 ou 43, qui comprend la sélection de l'empilage des bandes de fréquence en l'un parmi un empilage régulier et un empilage irrégulier, dans la largeur de bande de fréquence.

**46.** Procédé selon la revendication 34, qui comprend l'application du procédé à un signal d'information audio dans une prothèse auditive numérique.

**47.** Procédé selon la revendication 46, comprenant l'amélioration des bandes de basse fréquence par traitement supplémentaire.

**48.** Procédé selon la revendication 47, qui comprend la subdivision d'au moins une bande de basse fréquence en bandes plus petites pour traitement individuel.

**49.** Procédé selon la revendication 46, qui comprend la sélection du nombre de bandes et de la largeur des bandes, en fonction des délais acceptables et de la résolution souhaitée.

**50.** Procédé selon la revendication 42 ou 43 dans lequel le facteur de suréchantillonnage peut varier et est égal à au moins 2.

**51.** Procédé selon la revendication 43 dans lequel les coefficients de fenêtre d'analyse et les coefficients de fenêtre de synthèse peuvent varier.

FIGURE 1

FIGURE 2c

FIGURE 2d

EP 0 985 328 B1

N=8

| 2π/N | 2π/N | 2π/N | 2π/N | 2π/N | 2π/N | 2π/N | 2π/N |

$\omega_0=0$   $\omega_1$   $\omega_2$   $\omega_3$   $\omega_4=\pi$   $\omega_5$   $\omega_6$   $\omega_7$   $2\pi$   $\omega$

FIGURE 2a

N=8

| 2π/N | 2π/N | 2π/N | 2π/N | 2π/N | 2π/N | 2π/N | 2π/N |

$\omega_0$   $\omega_1$   $\omega_2$   $\omega_3$   $\pi$ $\omega_4$   $\omega_5$   $\omega_6$   $\omega_7$ $2\pi$   $\omega$

FIGURE 2b

EP 0 985 328 B1

50

X(1:R)

54

52

X

56

X(1:L)

57  57

60

58

W(1:L)  X

62

64  64

G(1:N/2) [odd]
G(1:N/2+1)[even]

68  70

Z(1:N)

72

X

64  64

66

74

+ ··· + + + + = 

U(1:N/2) [odd]
U(1:N/2+1) [even]

FIGURE 3

EP 0 985 328 B1

FIGURE 3a

FIGURE 4